(19) Europäisches Patentamt
European Patent Office
Office européen des brevets

(11) **EP 1 469 596 B1**

(12) **EUROPÄISCHE PATENTSCHRIFT**

(45) Veröffentlichungstag und Bekanntmachung des Hinweises auf die Patenterteilung:
**12.05.2010 Patentblatt 2010/19**

(51) Int Cl.:
***H03G 3/30*** (2006.01)

(21) Anmeldenummer: **04017074.8**

(22) Anmeldetag: **06.11.1997**

(54) **Verfahren zur Regelung der Leistungsverstärkung**

Method for controlling power gain

Procédé pour réguler l'amplification de puissance

(84) Benannte Vertragsstaaten:
**DE DK ES FI FR GB IT SE**

(30) Priorität: **23.01.1997 DE 19702280**

(43) Veröffentlichungstag der Anmeldung:
**20.10.2004 Patentblatt 2004/43**

(62) Dokumentnummer(n) der früheren Anmeldung(en) nach Art. 76 EPÜ:
**97948715.4 / 0 954 903**

(73) Patentinhaber: **IPCom GmbH & Co. KG**
**82049 Pullach (DE)**

(72) Erfinder:
• **Mader, Thomas**
**47509 Rheurdt (DE)**
• **Kottschlag, Gerhard**
**31139 Hildesheim (DE)**
• **Pitz, Gerhard**
**31139 Hildesheim (DE)**

(74) Vertreter: **Molnia, David et al**
**df-mp**
**Fünf Höfe**
**Theatinerstrasse 16**
**80333 München (DE)**

(56) Entgegenhaltungen:
**US-A- 5 159 283**

## Beschreibung

Stand der Technik

Die Erfindung geht von einem Verfahren zur Regelung der Leistungsverstärkung nach der Gattung des Hauptanspruchs aus.

Aus der "European Digital Cellular Telecommunications System (Phase 2); Radio Transmission and Reception (GSM 05.05), European Telecommunication Standard, Mai 1994" ist es bekannt, für die Abstrahlung eines Sendesignals von einer Mobilfunkvorrichtung die Abstrahlleistung zu Beginn des Sendesignals kontinuierlich auf eine vorgegebene Abstrahlleistung anzuheben und zu Ende des Sendesignals die vorgegebene Abstrahlleistung kontinuierlich abzusenken.

Aus der US 5,159,283 ist ein Leistungsverstärker bekannt, der ein abzustrahlendes Hochfrequenzsignal verstärkt. Dabei wird die Abstrahlleistung zu Beginn des Sendesignals entlang einer vorgegebenen Kennlinie auf eine vorgegebene Abstrahlleistung angehoben und zu Ende des Sendesignals entlang der vorgegebenen Kennlinie abgesenkt. Die beiden Kennlinien sind dabei als Referenzsteuersignale in einem ROM gespeichert. Das Steuersignal für den Leistungsverstärker wird dadurch gebildet, dass in Abhängigkeit eines Leistungssteuersignals das Referenzsteuersignal aus dem ROM gemäß einer vorgegebenen Abstrahlleistung auf einen vorgegebenen Wert begrenzt wird.

Vorteile der Erfindung

Das erfindungsgemäße Verfahren mit den Merkmalen des Hauptanspruchs hat demgegenüber den Vorteil, dass die Abstände zwischen den Zeiten, bei denen der Vergleich des Referenzsteuersignals mit dem vorgegebenen maximalen Steuersignalwert erfolgt, vorgegeben werden. Diese Vorgabemöglichkeit für die Zeitabstände während der gesamten Abstrahlung von Sendesignalen ermöglicht es auf einfache und flexible Weise, den Startzeitpunkt der Signalabsenkung und die Steilheit des benötigten Steuersignals den Erfordernissen anzupassen.

Durch die in den Unteransprüchen aufgeführten Maßnahmen sind vorteilhafte Weiterbildungen und Verbesserungen des im Hauptanspruch angegebenen Verfahrens möglich.

Vorteilhaft ist es, daß zur Einstellung der vorgegebenen Leistung für die Abstrahlung des Sendesignals, bei dem das Steuersignal auf einen entsprechend vorgegebenen maximalen Wert begrenzt wird, das Referenzsteuersignal mit dem vorgegebenen maximalen Steuersignalwert zu vorgegebenen Zeiten verglichen wird. Auf diese Weise ist eine äußerst einfache Ermittlung des Steuersignals für die Einstellung der angestrebten Abstrahlleistung des Sendesignals möglich, da keine aufwendigen Rechenoperationen wie beispielsweise Multiplikationen, sondern lediglich Vergleichsoperationen erforderlich sind.

Besonders vorteilhaft ist die Umschaltung vom Referenzsteuersignal auf den vorgegebenen maximalen Steuersignalwert zur Begrenzung des Steuersignals. Auf diese Weise ist eine besonders einfache Realisierungsmöglichkeit für die Begrenzung des Steuersignals auf den vorgegebenen maximalen Steuersignalwert gegeben.

Vorteilhaft ist auch die Abstrahlung der Sendesignale mit vorgegebenen Zeitversetzungen in Abhängigkeit der vorgegebenen Leistung. Auf diese Weise kann für verschiedene vorgegebene Leistungen eine vorgegebene Zeitschablone für die Abstrahlung des Sendesignals eingehalten werden.

Ein weiterer Vorteil besteht darin, daß solche Zeitversetzungen auf einfache Weise durch verzögertes Einsetzen des Sendesignals realisiert werden können.

Vorteilhaft ist weiterhin, die Anzahl der vom Steuersignal übernommenen Werte des Referenzsteuersignals in Abhängigkeit von der vorgegebenen Leistung zu wählen. Somit können Werte des Referenzsteuersignals, die den vorgegebenen maximalen Steuersignalwert überschreiten, auf einfache und wenig aufwendige Weise übersprungen werden.

Vorteilhaft ist weiterhin, daß mit Hilfe eines Detektors die tatsächlich erzielte Abstrahlleistung am Ausgang der Leistungsverstärkung ermittelt und als Regelgröße in einen Steuerungszweig der Leistungsverstärkung zurückgeführt wird. Diese Vorgehensweise stellt eine einfache Möglichkeit zur Regelung der Abstrahlleistung dar.

Zeichnung

Beispielhafte Verfahren zur Regelung der Leitungsverstärkung sowie ein Ausführungsbeispiel der Erfindung sind in der Zeichnung dargestellt und in der nachfolgenden Beschreibung näher erläutert. Es zeigen Figur 1 ein Blockschaltbild einer Regelung zur Leistungsverstärkung gemäß einem ersten Beispiel, Figur 2 einen Ablaufplan für die Wahl des Steuersignals gemäß dem ersten Beispiel, Figur 3 den Zeitverlauf dreier Steuersignale gemäß dem ersten Beispiel, Figur 4 ein Blockschaltbild eines zweiten Beispiels, Figur 5 einen Zeitverlauf dreier Steuersignale gemäß dem zweiten Beispiel, Figur 6 ein Blockschaltbild für u.a. das Ausführungsbeispiel der Erfindung, Figur 7 zwei Ablaufpläne für ein drittes Beispiel, Figur 8 einen Zeitverlauf dreier Steuersignale gemäß dem dritten Beispiel, Figur 9 den Ablaufplan für ein Ausführungsbeispiel der Erfindung, Figur 10 einen Zeitverlauf zweier Steuersignale gemäß dem Ausführungsbeispiel, Figur 11 zwei Ablaufpläne für ein viertes Beispiel, Figur 12 einen Zeitverlauf dreier Steuersignale gemäß dem vierten Beispiel, Figur 13 zwei Ablaufpläne für ein fünftes Beispiel und Figur 14 einen Zeitverlauf dreier Steuersignale gemäß dem fünften Beispiel.

Beschreibung der Beispiele und des Ausführungsbeispiels

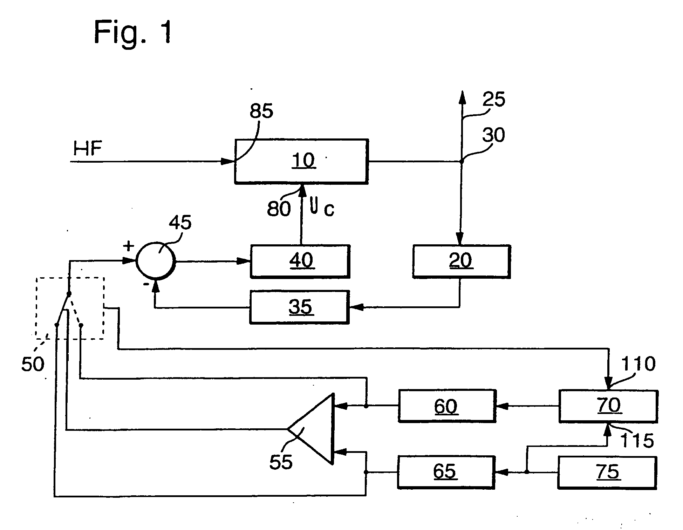

In Figur 1 kennzeichnet 10 einen Leistungsverstärker, dem an einem ersten Eingang 85 ein Hochfrequenz-Sendesignal zugeführt ist. Der Leistungsverstärker 10 ist ausgangsseitig über einen Antenneneinspeisepunkt 30 mit einer Sendeantenne 25 und mit dem Eingang eines Detektors 20 verbunden. Das Ausgangssignal des Detektors 20 ist über ein erstes Filter 35 dem invertierenden (-) Eingang eines Summierungspunktes 45 zugeführt. Das Ausgangssignal des Summierungspunktes 45 ist über ein zweites Filter 40 einem Steuereingang 80 des Leistungsverstärkers 10 zugeführt. Ein nicht invertierender Eingang (+) des Summierungspunktes 45 ist an einen Schalter 50 angeschlossen. Über den Schalter 50 ist der nicht invertierende Eingang (+) des Summierungspunktes 45 entweder mit dem Ausgang eines ersten Digital-Analog-Wandlers 60 oder mit dem Ausgang eines zweiten Digital-Analog-Wandlers 65 verbindbar. Die Schalterstellung des Schalters 50 wird dabei vom Ausgang eines Vergleichers 55 gesteuert, wobei der Vergleicher 55 zwei Eingänge aufweist, die ebenfalls mit dem Ausgang des ersten Digital-Analog-Wandlers 30 bzw. des zweiten Digital-Analog-Wandlers 65 verbunden sind. Der erste Digital-Analog-Wandler 60 ist eingangsseitig mit einem Speicher 70 und der zweite Digital-Analog-Wandler 65 ist eingangsseitig mit dem Ausgang einer Eingabeeinheit 75 verbunden. Das dem Steuereingang 80 des Leistungsverstärkers 10 zugeführte Steuersignal ist in Figur 1 als Steuerspannung $U_C$ dargestellt.

Der Schalter 50 ist zur Detektion seiner Schalterstellung mit einem ersten Eingang 110 des Speichers 70 verbunden. Da die Schalterstellung vom Vergleichsergebnis abhängt, kann diese Detektion auch direkt am Ausgang des Vergleichers 55 erfolgen. Der Ausgang der Eingabeeinheit 75 ist außerdem mit einem zweiten Eingang 115 des Speichers 70 verbunden.

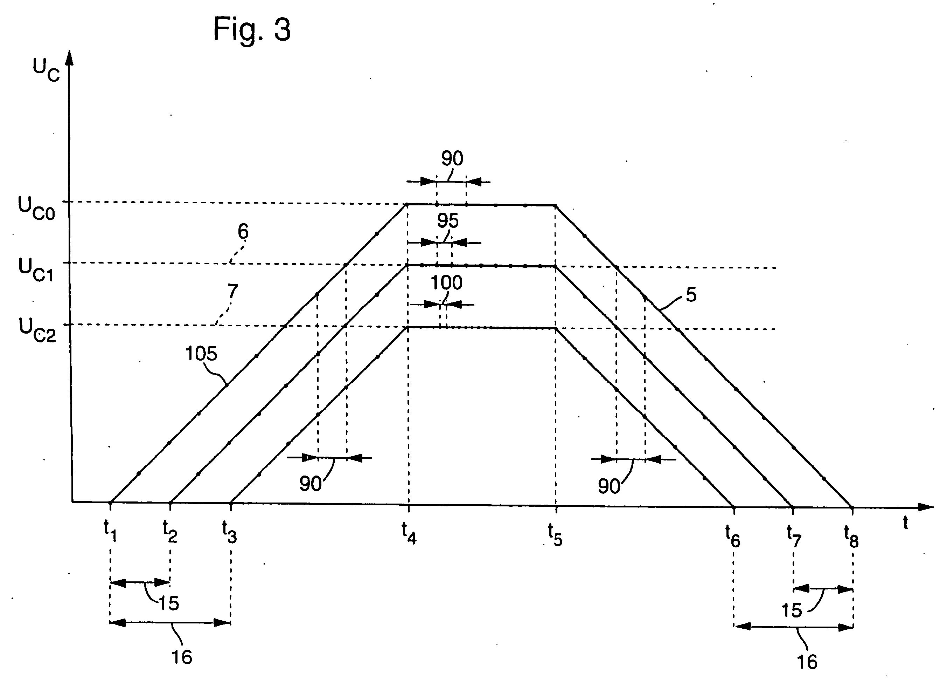

Die in Figur 1 beschriebene Anordnung kann beispielsweise Bestandteil eines Mobilfunksenders nach dem GSM-Standard sein. Die Spezifikationen zum GSM-Mobilfunk schreiben vor, daß die Senderendstufen beim Beginn und Ende eines Sendesignals nicht hart ein- bzw. ausgeschaltet, sondern mit einem analogen Steuersignal $U_C$ entlang einer geeigneten Kennlinie auf- und zugeregelt werden, so daß möglichst wenig Nebenwellen entstehen. Dabei wird nur eine einzige Kennlinie vorgegeben, die in einem Referenzsteuersignal 5 gemäß Figur 3 zum Ausdruck kommt. Figur 3 stellt dabei ein Diagramm für Steuersignale $U_C$ über der Zeit t dar. Das Referenzsteuersignal 5 steigt von einem Zeitpunkt $t_1$ bis zu einem Zeitpunkt $t_4$ auf seinen Maximalwert $U_{C0}$ an und fällt von einem Zeitpunkt $t_5$ bis zu einem Zeitpunkt $t_8$ mit der betragsmäßig gleichen Steigung wieder auf 0 ab. Die Steigungen können auch unterschiedlich gewählt werden. Die in Figur 3 dargestellte Kurve des Referenzsteuersignals 5 stellt in vereinfachter Form eine Interpolation von äquidistanten Stützstellen 105 dar, die jeweils durch einen ersten Zeitabstand 90 voneinander getrennt sind. Die Stützstellen sind dabei im Speicher 70 digital gespeichert. Sie werden zu den entsprechenden vorgegebenen Zeiten vom ersten Digital-Analog-Wandler 60 in analoge Signalwerte gewandelt. Bei Zuführung des Maximalwertes $U_{C0}$ an den Steuereingang 80 des Leistungsverstärkers 10 wird am Leistungsverstärker 10 die maximale Abstrahlleistung für die Hochfrequenz-Sendesignale eingestellt.

Der in Figur 3 dargestellte Verlauf des Referenzsteuersignals 5 dient zur Veranschaulichung des Verfahrens und ist vor allem bezüglich seiner ansteigenden und seiner abfallenden Flanke an die vorgegebenen Spezifikationen beispielsweise für den Mobilfunk nach GSM-Standard anzupassen. An der Eingabeeinheit 75 kann die Leistung zur Abstrahlung des Hochfrequenz-Sendesignals über die Sendeantenne 25 vorgegeben werden. Dazu wird in der Eingabeeinheit 75 ein zur Erzielung der vorgegebenen Abstrahlleistung erforderlicher maximaler Steuersignalwert 6, 7 in digitalisierter Form ermittelt. Durch den zweiten Digital-Analog-Wandler 65 wird der vorgegebene maximale Steuersignalwert 6, 7 in analoger Form an den entsprechenden Eingang des Vergleichers 55 abgegeben.

Die an der Eingabeeinheit 75 vorgebbaren Abstrahlleistungen sind dabei kleiner oder gleich der maximal möglichen Abstrahlleistung am Ausgang des Leistungsverstärkers 10. Somit sind auch die vorgegebenen maximalen Steuersignalwerte 6, 7 kleiner oder gleich dem Maximalwert $U_{C0}$ gemäß Figur 3. In Figur 3 liegt ein erstes Maximalsteuersignal 6 mit einem Wert $U_{C1}$ unterhalb dem Maximalwert $U_{C0}$ und ein zweites maximales Steuersignal 7 liegt mit seinem Wert $U_{C2}$ unterhalb des Wertes $U_{C1}$ für das erste maximale Steuersignal 6.

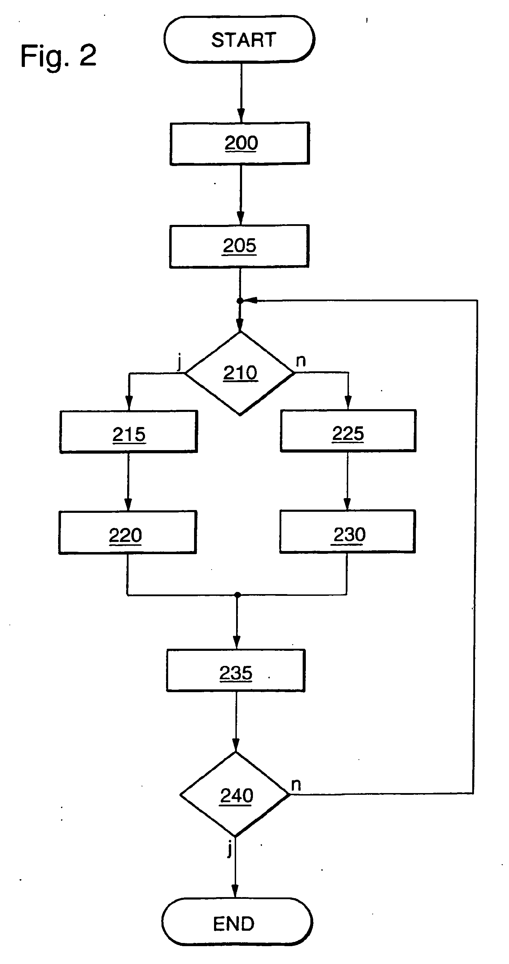

In Figur 2 ist ein Ablaufplan zur Erzeugung des auf den nicht invertierenden Eingang (+) des Summierungspunktes 45 gegebenen Steuersignals dargestellt. Bei einem Programmschritt 200 wird aus dem Speicher 70 der erste Stützstellenwert des Referenzsteuersignals 5 an den Vergleicher 55 abgegeben. Dieser Wert ist gemäß Figur 3 gleich Null.

Bei einem Programmschritt 205 wird eine Zeitverzögerung 15, 16 bewirkt. Die Zeitverzögerung 15, 16 ist dabei im Speicher 70 gespeichert. Ihre Wahl hängt von den Zielvorgaben zur Sendersteuerung gemäß der Spezifikation nach dem GSM-Standard ab. Bei Programmpunkt 210 wird geprüft, ob der vom Speicher 70 dem Vergleicher 55 zugeführte Stützwert des Referenzsteuersignals 5 kleiner oder gleich dem vorgegebenen maximalen Steuersignalwert 6, 7 ist. Ist dies der Fall, so wird zu Programmpunkt 215 verzweigt, andernfalls wird zu Programmpunkt 225 verzweigt. Bei Programmpunkt 215 wird der Schalter 50 in eine erste Schalterstellung, die in Figur 1 gestrichelt dargestellt ist, gebracht, falls sich der Schalter 50 nicht bereits in der ersten Schalterstellung befindet. In der ersten Schalterstellung des Schalters 50 ist der Ausgang des ersten Digital-Analog-Wandlers 60 mit dem nicht invertierenden Eingang (+) des Summierungspunktes 45 verbunden, so daß der Stützwert als Steuersignal für den Leistungsverstärker 10 vorgesehen ist. Anschließend wird zu Programmpunkt 220 verzweigt. Bei Programmpunkt 220 wird eine dem ersten Zeitabstand 90 entsprechende erste Wartezeit eingestellt. Bei Programmpunkt 225 wird der Schalter 50 vom Vergleicher 55 in die zweite Schalterstellung, die in Figur 1 als durchgezogener Strich dargestellt ist gebracht, so daß in diesem Fall der Ausgang des zweiten Digital-Analog-Wandlers 65 mit dem nicht invertierenden Eingang (+) des Summierungspunktes 45 verbunden wird, so daß als Steuersignal $U_C$ für den Leistungsverstärker 10 der vorgegebene maximale Steuersignalwert 6, 7 verwendet wird. Das Umschalten des Schalters 50 wird am ersten Eingang 110 des Speichers 70 detektiert. Daraufhin wird bei Programmpunkt 230 in Abhängigkeit des dem zweiten Eingang 115 des Speichers 70 zugeführten vorgegebenen maximalen Steuersignalwertes 6, 7 eine zweite Wartezeit eingestellt, die nur dann der ersten Wartezeit entspricht, wenn der vorgegebene maximale Steuersignalwert 6, 7 den Wert $U_{C0}$ annimmt. Von Programmpunkt 220 und Programmpunkt 230 wird jeweils zu Programmpunkt 235 verzweigt. Bei Programmpunkt 235 wird die nächste Stützstelle des Referenzsteuersignals 5 aus dem Speicher 70 an den Vergleicher 55 weitergeleitet. Bei Programmpunkt 240 wird geprüft, ob bereits alle Stützstellen vom Speicher 70 an den Vergleicher 55 weitergeleitet wurden. Ist dies der Fall so wird der Ablauf beendet, andernfalls wird zu Programmpunkt 210 zurückverzweigt. Wird im Speicher 70 ein Umschalten des Schalters 50 von der zweiten Schalterstellung auf die erste Schalterstellung detektiert, so wird als zeitlicher Abstand zur Abgabe der Stützstellen aus dem Speicher 70 wieder die erste Wartezeit eingestellt. Die bei Programmpunkt 205 eingestellten Zeitversetzungen 15, 16 sind ebenfalls im Speicher 70 gespeichert und entsprechend den vorgegebenen maximalen Steuersignalwerten 6, 7 zugeordnet. Dabei werden mit Abnahme der an der Eingabeeinheit 75 vorgegebenen Abstrahlleistungen den resultierenden vorgegebenen maximalen Steuersignalwerten 6, 7 zunehmende vorgegebene Zeitversetzungen 15, 16 im Speicher 70 zugeordnet. So ergibt sich bei dem ersten vorgegebenen maximalen Steuersignalwert 6 eine erste Zeitversetzung 15, die kleiner ist als die zweite Zeitversetzung 16 für den zweiten vorgegebenen maximalen Steuersignalwert 7. Folglich setzt das sich für den ersten vorgegebenen maximalen Steuersignalwert 6 ergebende Steuersignal 8 gemäß Figur 3 im Vergleich zum Referenzsteuersignal 5 zu einem Zeitpunkt $t_2$, der gegenüber dem Zeitpunkt $t_1$ um die erste vorgegebene Zeitversetzung 15 verzögert ist, ein. Das sich für den zweiten vorgegebenen maximalen Steuersignalwert 7 ergebende Steuersignal 9 setzt gemäß Figur 3 entsprechend zu einem Zeitpunkt $t_3$ ein, der gegenüber dem Zeitpunkt $t_1$ des Referenzsteuersignals 5 noch mehr verzögert ist, als der Zeitpunkt $t_2$. Die vorgegebenen Zeitversetzungen 15, 16 sind dabei so gewählt, daß alle Anforderungen der Spezifikation nach dem GSM-Standard erfüllt werden, so daß beispielsweise alle sich ergebenden Steuersignale 8, 9 zu einem Zeitpunkt $t_4$ ihren Maximalwert erreichen. Dies ist insofern von Bedeutung, als für die Abstrahlung von Sendesignalen beispielsweise nach dem GSM-Mobilfunkstandard sogenannte Zeit-Schablonen vorgesehen sind, in denen die Hochfrequenz-Sendesignale mit der vorgegebenen Leistung abzustrahlen sind. Durch Verwendung der Stützstellen des Referenzsteuersignals 5 für die Ermittlung des Steuersignals 8, 9 weisen alle Steuersignale 8, 9 für den Anstieg bis zu ihrem Maximalwert jeweils die gleiche Kurvenform auf. Dasselbe gilt für den Rückgang der Signalamplitude des jeweiligen Steuersignals 8, 9 auf den Wert 0. Da für den Anstieg und den Rückgang des jeweiligen Steuersignals 8, 9 zwischen den einzelnen Stützstellen jeweils der gleiche erste Zeitabstand 90 vorliegt, muß der Zeitabstand zwischen den Stützstellen für den Fall, daß das jeweilige Steuersignal 8, 9 seinen Maximalwert einnimmt, mit abnehmenden vorgegebenen maximalen Steuersignalwert 6, 7 verringert werden, damit alle im Speicher 70 abgelegten Stützwerte zur Erzeugung des jeweiligen Steuersignals 8, 9 dem Vergleicher 55 zugeführt werden können. So ergibt sich in Figur 3 für den ersten vorgegebenen maximalen Steuersignalwert 6 das Steuersignal 8, bei dem die zweite Wartezeit zwischen zwei Stützstellen beim maximalen Steuersignalwert $U_{C1}$ einem zweiten Zeitabstand 95 entspricht, der kleiner als der erste Zeitabstand 90 ist. Für den zweiten vorgegebenen maximalen Steuersignalwert 7 ergibt sich das Steuersignal 9, bei dem die zweite Wartezeit zwischen zwei Stützstellen beim maximalen Steuersignalwert $U_{C2}$ einem dritten Zeitabstand 100 entspricht, der kleiner als der zweite Zeitabstand 95 ist. Dabei ist die zweite Wartezeit jeweils so gewählt, daß alle Steuersignale 8, 9 bis zu einem Zeitpunkt $t_5$ ihren Maximalwert halten und vom Zeitpunkt $t_5$ an zurückgehen. Vom Zeitpunkt $t_5$ an wird für alle Steuersignale 8, 9 wieder die erste Wartezeit zwischen zwei Stützstellen eingestellt, die dem ersten Zeitabstand 90 entspricht. Auf diese Weise erreicht das Steuersignal 9 mit dem Maximalwert $U_{C2}$ zu einem Zeitpunkt $t_6$ den Amplitudenwert Null, gegenüber dem der Zeitpunkt $t_8$ für den Nulldurchgang des Referenzsteuersignals 5 um die zweite vorgegebene Zeitversetzung 16 verzögert ist. Das Steuersignal 8 mit dem Maximalwert $U_{C1}$ erreicht den Amplitudenwert 0 zu einem Zeitpunkt $t_7$, gegenüber dem der Zeitpunkt $t_8$ für den Nulldurchgang des Referenzsteuersignals 5 um die erste vorgegebene Zeitversetzung 15 verzögert ist.

Das erste und das zweite Filter 35 und 40 kann zusätzlich zur Stabilisierung des Regelkreises verwendet werden, so daß es beispielsweise nicht zu Aufschwingvorgängen kommt. Mit Hilfe des Detektors 20 wird die tatsächlich erzielte Hochfrequenz-Ausgangsleistung am Antenneneinspeisepunkt 30 ermittelt und als Regelgröße über den invertierenden Eingang (-) des Summierungspunktes 45 in den Steuerungszweig des Leistungsverstärkers 10 zurückgeführt.

Um Speicherplatz im Speicher 70 zu sparen, kann Gruppen beieinanderliegender vorgegebener maximaler Steuersignalwerte jeweils eine vorgegebene Zeitversetzung zugeordnet werden. Die sich dabei ergebenden Variationen des Zeitpunktes $t_4$ für das Erreichen der Maximalamplitude des jeweiligen Steuersignals $U_C$ muß dabei innerhalb eines vorgegebenen Toleranzbereiches beispielsweise gemäß dem GSM-Mobilfunkstandard liegen. Die Komponenten des in Figur 1 dargestellten Regelkreises müssen so sorgfältig dimensioniert werden, daß alle Anforderungen vorgegebener Spezifikationen, wie beispielsweise des GSM-Mobilfunkstandard hinsichtlich der Zeitvorgaben für das Hochfrequenz-Sendesignal und der spektralen Breite des Sendesignals bei allen vorgegebenen Abstrahlleistungen erfüllt werden.

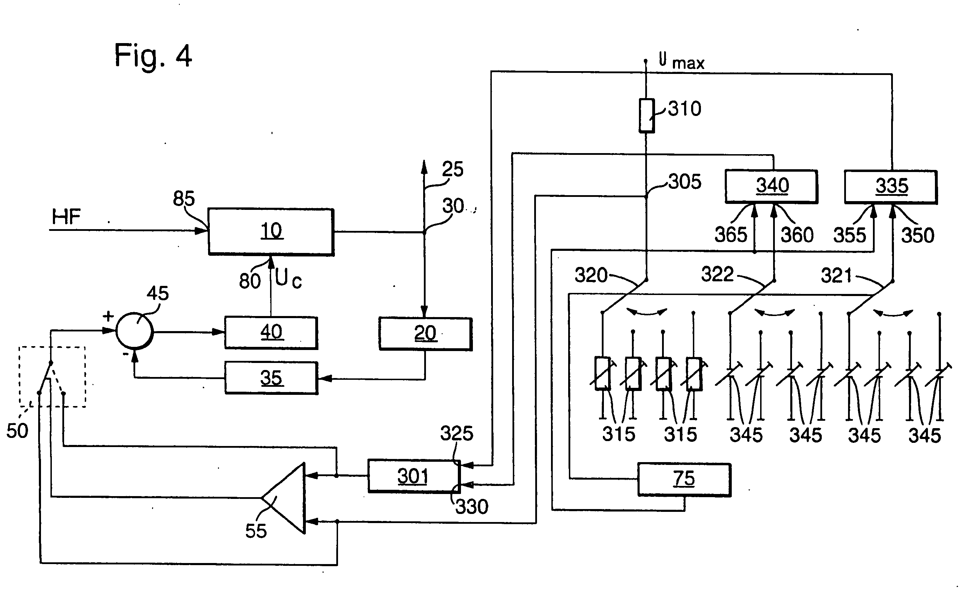

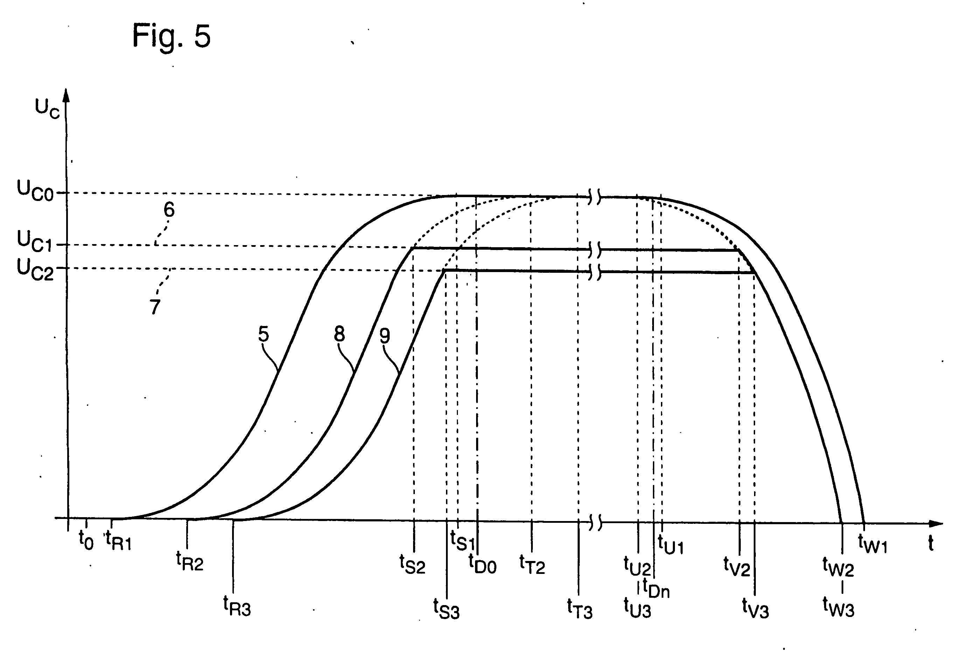

Figur 4 zeigt ein weiteres Beispiel für ein Verfahren zur Regelung der Leistungsverstärkung. Ausgangspunkt dafür ist das Blockschaltbild gemäß Figur 1. Gleiche Teile sind mit gleichen Bezugszeichen gekennzeichnet. Der Regelkreis ist dabei wie in Figur 1 ausgeführt. Die Erzeugung des auf den nicht invertierenden Eingang (+) des Summierungspunktes 45 gegebenen Steuersignals ist jedoch anders realisiert. Der nicht invertierende Eingang (+) des Summierungspunktes 45 ist an den Schalter 50 angeschlossen. Über den Schalter 50 ist der nicht invertierende Eingang (+) des Summierungspunktes 45 entweder mit dem Ausgang eines Signalgenerators 301 zur Erzeugung des Steuersignals 5 oder mit der Mittelanzapfung 305 eines schaltbaren Spannungsteilers aus einem ersten Widerstand 310 und einem zweiten zuschaltbaren Widerstand 315 verbindbar. Der erste Widerstand 310 des Spannungsteilers ist dabei an ein erstes Potential $U_{max}$, und der zweite Widerstand 315 des Spannungsteilers ist an ein Bezugspotential angeschlossen. Über eine erste Schaltvorrichtung 320 sind drei weitere Widerstände 315 jeweils als zweiter zuschaltbarer Widerstand des Spannungsteilers mit der Mittelanzapfung 305 des Spannungsteilers verbindbar. Die zuschaltbaren Widerstände 315 des Spannungsteilers sind als Trimmpotentiometer ausgebildet. Die Schalterstellung des Schalters 50 wird vom Ausgang des Vergleichers 55 gesteuert, wobei der Vergleicher 55 zwei Eingänge aufweist, die ebenfalls mit dem Ausgang des Signalgenerators 301 bzw. der Mittelanzapfung 305 des Spannungsteilers verbunden sind. Der Signalgenerator 301 weist einen ersten Eingang 325 und einen zweiten Eingang 330 auf. Der erste Eingang 325 ist mit dem Ausgang eines ersten Monoflops 335 und der zweite Eingang 330 ist mit dem Ausgang eines zweiten Monoflops 340 verbunden. Über eine zweite Schaltvorrichtung 321 ist ein erster Eingang 350 des ersten Monoflops 335 mit jeweils einem von vier Trimmerkondensatoren 345 verbindbar, deren nicht mit der zweiten Schaltvorrichtung 321 verbindbaren Elektroden jeweils mit dem Bezugspotential verbunden sind. Ein erster Eingang 360 des zweiten Monoflops 340 ist über eine dritte Schaltvorrichtung 322 ebenfalls mit jeweils einem von vier weiteren Trimmerkondensatoren 345 verbindbar, deren nicht mit der dritten Schaltvorrichtung 322 verbundene Elektroden jeweils ebenfalls mit dem Bezugspotential verbunden sind. Ein zweiter Eingang 355 des ersten Monoflops 335 und ein zweiter Eingang 322 des zweiten Monoflops 340 sind an eine Eingabeeinheit 75 angeschlossen, die außerdem die Schalterstellung der Schaltvorrichtungen 320, 321 und 322 steuert. Die zuschaltbaren Widerstände 315 und die Trimmerkondensatoren 345 werden als Speichereinheiten zur Speicherung von Parametersätzen verwendet. Jeder Parametersatz besteht aus einem vorgegebenen maximalen Steuersignalwert 6, 7, einer ersten Zeitkonstante für die Zeitverzögerung bei der Signalanhebung und einer zweiten Zeitkonstanten für die Zeitverzögerung bei der Signalabsenkung, so daß die beiden vorgegebenen Zeitversetzungen 15, 16 für die Signalanhebung und die Signalabsenkung unterschiedlich sein können. Der vorgegebene maximale Steuersignalwert 6, 7 ist in diesem Beispiel als Einstellung des entsprechenden als Trimmpotentiometer ausgebildeten jeweiligen zuschaltbaren Widerstandes 315 gespeichert, so daß an der Mittelanzapfung 305 des Spannungsteilers die zur Einstellung des vorgegebenen maximalen Steuersignalwertes 6, 7 erforderliche Signalspannung dem Vergleicher 55 zugeführt wird. Die Werte für die Zeitversetzungen 15, 16 sind in analoger Weise mittels der Trimmkondensatoren 345 gespeichert, wobei die mit dem ersten Monoflop 335 verbindbaren Trimmkondensatoren 345 die zeitkonstante des ersten Monoflops 335 und die mit dem zweiten Monoflop 340 verbindbaren Trimmkondensatoren 345 die Zeitkonstante für das zweite Monoflop 340 festlegen. Die Umschaltung von einem Parametersatz auf einen anderen Parametersatz erfolgt dabei synchron über die Eingabeeinheit 370, die die Schaltvorrichtungen 320, 321, 322 gleichzeitig umschaltet. Der zweite Eingang 355 des ersten Monoflops 335 und der zweite Eingang 365 des zweiten Monoflops 340 werden gemäß Figur 5 zum Zeitpunkt $t_0$ durch die Eingabeeinheit 75 aktiviert. Dadurch wird die Aussendung eines Sendesignals initiiert. Nach verstreichen einer ersten Wartezeit $t_R$ aktiviert das erste Monoflop 335 den ersten Eingang 325 des Signalgenerators 301, der daraufhin die ansteigende Flanke des Referenzsteuersignals 5 in analoger Form als kontinuierliches Signal an seinem Ausgang abgibt und beim Maximalwert dieses Referenzsteuersignals 5 verharrt, bis das zweite Monoflop 340 nach Ablauf einer zweiten Wartezeit $t_U$ abgelaufen ist und über den zweiten Eingang 330 des Signalgenerators 301 den Beginn der Signalabsenkung anstößt. In Figur 5 ist der Spannungsverlauf dreier Steuersignale $U_C$ über der Zeit t dargestellt. Das vom Signalgenerator 301 erzeugte Referenzsteuersignal 5 wird zur Erzeugung des maximalen Sendepegels verwendet. Ist der mit dem entsprechenden Trimmpotentiometer 315 eingestellte maximale Steuersignalwert 6, 7 größer oder gleich dem Maximalwert $U_{C0}$ des Referenzsteuersignals 5, so bleibt der Schalter 50 immer in der Stellung, die den Ausgang des Signalgenerators 301 mit dem Summierungspunkt 45 verbindet. An der Eingabeeinheit 75 können Parametersätze über die Schaltvorrichtungen 320, 321, 322 ausgewählt werden, und außerdem können die Werte der zuschaltbaren Widerstände 315 und der Trimmkondensatoren 345 an der Eingabeeinheit 75 eingestellt werden. Weiterhin dient die Eingabeeinheit 75 dazu, einen Sendevorgang zu starten, so daß zum Zeitpunkt $t_0$ die beiden Monoflops 335, 340 aktiviert werden. Die Einstellung der maximal vorgebbaren Steuersignalwerte 6, 7 hängt vom ersten Potential $U_{max}$, vom Bezugspotential, vom ersten Widerstand 310 des Spannungsteilers, vom gewählten zuschaltbaren Widerstand 315 und dessen Größe ab. Wenn an der Eingabeeinheit 75 ein Parametersatz mit einem vorgegebenen maximalen Steuersignalwert 6, 7 ausgewählt wurde, der kleiner als der Maximalwert $U_{C0}$ des Referenzsteuersignals 5 ist, so erreicht der Pegel des Steuersignals 8,9 gemäß Figur 5 zu einem Zeitpunkt $t_S$ den Wert des vorgegebenen maximalen Steuersignalwertes 6, 7. Bei Überschreiten dieses Wertes schaltet der Vergleicher 55 den Schalter 50 um, so daß nicht mehr der Ausgang des Signalgenerators 301 mit dem Summmierungspunkt 45 verbunden ist, sondern die Mittelanzapfung 305 des Spannungsteilers. Diese Schalterstellung des Schalters 50 wird bis zu einem Zeitpunkt $t_V$ beibehalten, denn zu diesem Zeitpunkt sinkt das Steuersignal 8, 9 unter den Wert des vorgegebenen maximalen Steuersignalwertes 6, 7 und der Vergleicher 55 stellt den Schalter 55 zurück in die Stellung, die den Ausgang des Signalgenerators 301 mit dem Summierungspunkt 45 verbindet. Zum Zeitpunkt $t_W$ erreicht das Steuersignal 8, 9 dann wieder den Wert Null.

In Figur 5 ist zunächst das Referenzsteuersignal 5 dargestellt, das zu einem Zeitpunkt $t_{R1}$ veranlaßt durch das erste Monoflop 335 einsetzt und zu einem Zeitpunkt $t_{S1}$ seinen Maximalwert $U_{C0}$ erreicht. Von einem Zeitpunkt $t_{D0}$ an, der dem Zeitpunkt $t_{S1}$ nachfolgt, ist gemäß den Zeitschablonen des GSM-Mobilfunkstandards das entsprechende Hochfrequenz-Sendesignal mit der vorgegebenen maximalen Leistung abzustrahlen. Dies muß bis zu einem Zeitpunkt $t_{Dn}$, die dem Zeitpunkt $t_{D0}$ nachfolgt, gemäß dem GSM-Mobilfunkstandard beibehalten werden. Zu einem Zeitpunkt $t_{U1}$, der dem Zeitpunkt $t_{Dn}$ nachfolgt, wird, durch das zweite Monoflop 340 veranlaßt, das Absinken des Referenzsteuersignals 5 eingeleitet, so daß es zu einem Zeitpunkt $t_{W1}$ die Nullachse wieder schneidet. Wird an der Eingabeeinheit 75 für den ersten vorgegebenen maximalen Steuersignalwert 6 der Wert $U_{C1}$, der kleiner als $U_{C0}$ ist, eingestellt, und die Zeitkonstanten der beiden Monoflops 335, 340 entsprechend gewählt, so setzt das erste Steuersignal 8 veranlaßt durch das erste Monoflop 335 zu einem Zeitpunkt $t_{R2}$ ein, der gegenüber dem Zeitpunkt $t_{R1}$ verzögert ist, und weist bis zum Zeitpunkt $t_{S2}$ die Form des Referenzsteuersignals 5 auf. Zum Zeitpunkt $t_{S2}$ wird der Wert $U_{C1}$ erreicht, wobei dieser Zeitpunkt vor dem Zeitpunkt $t_{S1}$ liegt. Somit ist zum Zeitpunkt $t_{D0}$ ebenfalls die maximal vorgegebene Sendeleistung eingestellt. In Figur 5 ist gestrichelt die Fortsetzung des Verlaufs des ersten Steuersignals 8 bis zum Erreichen des Wertes $U_{C0}$ dargestellt, der zu einem Zeitpunkt $t_{T2}$ erreicht würde, der zeitlich nach dem Zeitpunkt $t_{T0}$ kommt. Zu einem Zeitpunkt $t_{U2}$, der vor dem Zeitpunkt $t_{Dn}$ kommt, beginnt dann das vom Signalgenerator 301 erzeugte Referenzsteuersignal 5 auf Veranlassung des zweiten Monoflops 340 abzusinken, so daß es zu einem Zeitpunkt $t_{v2}$, der nach dem Zeitpunkt $t_{Dn}$ kommt, den Wert $U_{C1}$ erreicht, so daß das dem Summierungspunkt 45 zugeführte erste Steuersignal 8 bis zum Zeitpunkt $t_{V2}$ auf dem Wert $U_{C1}$ bleibt und vom Zeitpunkt $t_{V2}$ an gemäß dem Verlauf des Referenzsteuersignals 5 absinkt und zu einem Zeitpunkt $t_{W2}$ die Nullachse erreicht. Dadurch wird auch in diesem Fall zwischen dem Zeitpunkt $t_{D0}$ und dem Zeitpunkt $t_{Dn}$ das Sendesignal mit dem vorgegebenen maximalen Pegel abgestrahlt.

Entsprechendes gilt für das zweite Steuersignal 9 gemäß Figur 5, dessen Maximalwert $U_{C2}$ ist und das bedingt durch das erste Monoflop 335 zu einem Zeitpunkt $t_{R3}$ einsetzt, der gegenüber dem Zeitpunkt $t_{R2}$ verzögert ist, das gemäß dem Verlauf des Referenzsteuersignals 5 bis zum Maximalwert $U_{C2}$ ansteigt und diesen zu einem Zeitpunkt $t_{S3}$ erreicht, der zwischen dem Zeitpunkt $t_{S1}$ und dem Zeitpunkt $t_{S2}$ liegt, wobei das zweite Monoflop 340 zu einem Zeitpunkt $t_{U3}$, der gleich dem Zeitpunkt $t_{U2}$ ist, das Absinken des vom Signalgenerator 301 erzeugten Referenzsteuersignals 5 veranlaßt, welches dann zu einem Zeitpunkt $t_{V3}$, der gegenüber dem Zeitpunkt $t_{V2}$ verzögert ist, den Wert $U_{C2}$ erreicht, und vom Zeitpunkt $t_{V3}$ sinkt dann das zweite Steuersignal 9 gemäß dem Verlauf des Referenzsteuersignals 5 auf den Wert Null ab, den es zum Zeitpunkt $t_{W3}$ erreicht, welcher gleich dem Zeitpunkt $t_{W2}$ ist. Auch in diesem Fall wird die Fortsetzung des Verlaufs des zweiten Steuersignals 9 bis zum Erreichen des maximal möglichen Wertes $U_{C0}$ gestrichelt weiter gezeichnet, wobei der Wert $U_{C0}$ zu einem Zeitpunkt $t_{T3}$ erreicht würde, welcher gegenüber dem Zeitpunkt $t_{T2}$ verzögert ist. Auch der Abfall des vom Signalgenerator 301 erzeugten Referenzsteuersignals 5 vom Maximalwert $U_{C0}$ bis zu dem vorgegebenen maximalen Steuersignalwert 6, 7 ist in Figur 5 gestrichelt dargestellt. Auch bei Vorgabe des zweiten maximalen Steuersignalwertes 7 mit dem Wert $U_{C2}$ wird dieser Wert bis zum Zeitpunkt $t_{V3}$ von dem dem Summierungspunkt 45 zugeführten zweiten Steuersignal 9 beibehalten. Die in Figur 5 gestrichelt dargestellten Kurven stellen dabei die vom Signalgenerator 301 erzeugten Steuersignale dar, die aufgrund der Schalterstellung des Schalters 50 nicht zum Summierungspunkt 45 gelangen. Die eigentliche Datenaussendung erfolgt zwischen dem Zeitpunkt $t_{D0}$ und dem Zeitpunkt $t_{Dn}$.

Der Vorteil bei der Erzeugung des Steuersignals 8, 9 durch eine Hardware-Schaltung gemäß Figur 4 ohne digitale Speicherung von Stützstellen liegt in der Einsparung von Rechenoperationen und einer Vereinfachung der Signalfilterung, da keine Digital-Analog-Wandlung erfolgt, so daß kein Störsignal aufgrund einer Digital-Analog-Wandler-Taktung erzeugt wird.

Die hier beschriebene Anordnung kann beispielsweise Bestandteil eines Mobilfunksenders nach dem GSM-Standard sein. Spezifikationen zum GSM-Mobilfunk enthalten Vorgaben über die zeitliche Abfolge des Sendesignalanstiegs und -abfalls für verschiedene Stufungen der Sendeausgangsleistung. Darüber hinaus enthalten sie auch Angaben bezüglich der zulässigen Breite des gesendeten Frequenzspektrums. Durch die Wahl der Zeitverzögerungen $t_R$ und $t_U$ und durch die sorgfältige Dimensionierung der Filter 35, 40 muß sichergestellt werden, daß diese Anforderungen bei allen Abstrahlleistungen erfüllt werden.

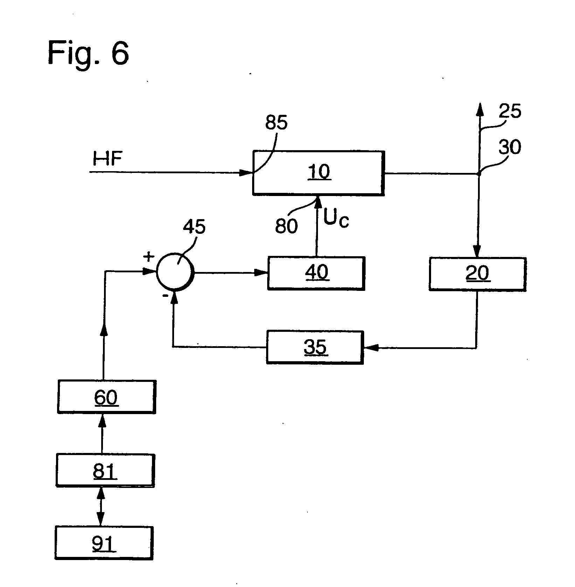

In Figur 6 ist der Regelkreis weiterhin unverändert im Vergleich zur Figur 1. Jedoch wurde für die Erzeugung des dem nicht invertierenden Eingang (+) des Summierungspunktes 45 zugeführten Steuersignals eine andere Realisierung gewählt. An dem nicht invertierenden Eingang (+) des Summierungspunktes 45 ist nun der Ausgang eines Digital-Analog-Wandlers 60 angeschlossen, der von einer Ablaufsteuerung 81 den Digitalwert des auszugebenden analogen Steuersignals erhält. Die Ablaufsteuerung 81, die beispielsweise als Mikrocomputer ausgeführt sein kann, hat Zugriff auf den Inhalt eines Datenspeichers 91, in dem die Stützstellen des Referenzsteuersignals 5 und verschiedene Parameter zur Erzeugung der für verschiedene vorgebbare maximale Steuersignalwerte 6, 7 vom Referenzsteuersignal 5 abzuleitenden Steuersignalen 8, 9 abgelegt sind. Dabei sollen m verschiedene Leistungsstufen für die Abstrahlung von Sendesignalen über die Sendeantenne 25 einstellbar sein. Für jede der m möglichen Leistungsstufen ist jeweils ein Wert für die Zeitverzögerung des Sendebeginns, den vorgegebenen maximalen Steuersignalwert 6, 7 des für diese Leistung benötigten Steuersignals 8, 9 und eine Anzahl der beim Absenken des jeweiligen Steuersignals 8, 9 zu überspringenden Stützstellen im Datenspeicher 91 abgelegt.

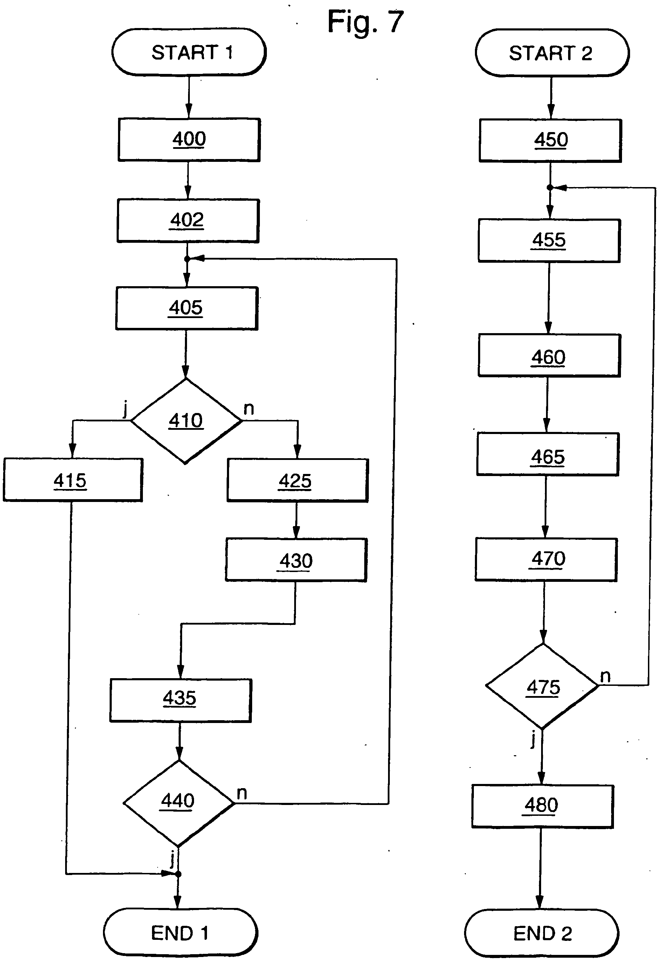

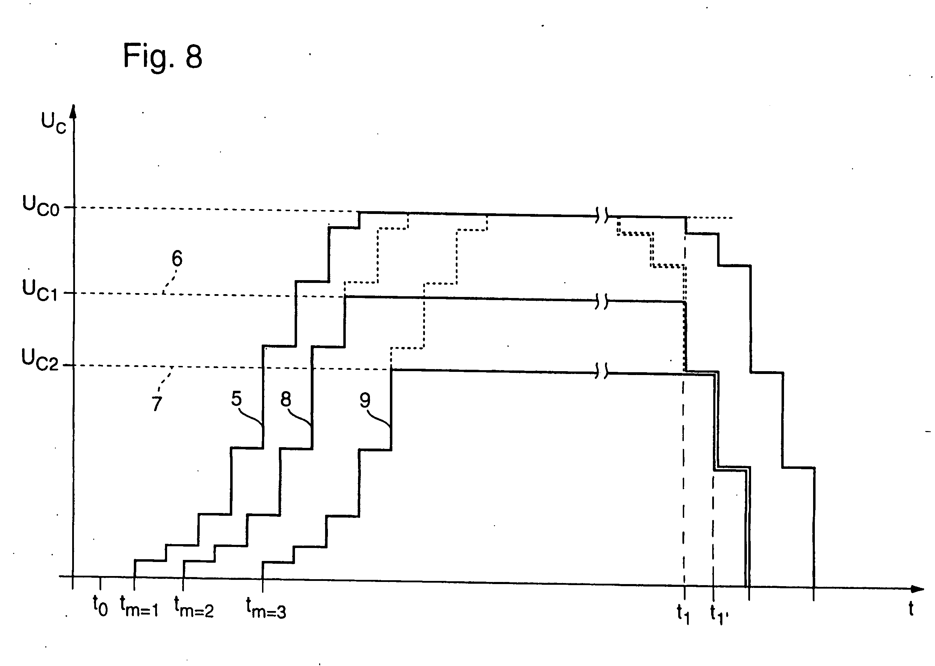

In Figur 7 sind zwei Ablaufpläne zur Erzeugung des für eine gewünschte Sendeausgangsleistung benötigten Steuersignals 8, 9 dargestellt. In Figur 8 ist für drei Leistungsstufen des Senderausgangssignals der Verlauf der Spannungen der Steuersignale 8, 9 über der Zeit t dargestellt. Dabei wurden für die maximal vorgegebenen Steuersignalwerte 6, 7 wieder die Werte $U_{C1}$ und $U_{C2}$ gemäß den Figuren 3 und 5 gewählt. Der Maximalwert $U_{C0}$ des Referenzsteuersignals 5 wird ebenfalls gemäß den Figuren 3 und 5 gewählt. Zu einem Zeitpunkt $t_o$ vor Beginn der Sendesignalanhebung wird eine erste Sequenz von Stützstellen des Referenzsteuersignals 5 beim Programmpunkt START 1 aufgerufen. Bei diesem Aufruf wird dem Programm der Wert m für die gewünschte Leistungsstufe der Senderausgangsleistung zur Verfügung gestellt, die der Ablaufsteuerung 81 durch eine Basisstation per Funk übermittelt wurde. Bei Programmpunkt 400 wird der Zugriff auf die im Datenspeicher 91 abgelegte erste Stützstelle der ersten Sequenz des Referenzsteuersignals 5 durch Initialisierung einer Indexvariablen vorbereitet. Bei Programmpunkt 402 wird der für die Stufe m abgespeicherte Wert für die Zeitverzögerung des Sendebeginns $t_m$ aus dem Datenspeicher 91 ausgelesen. Nach Ablauf der Wartezeit $t_m$ wird bei Programmpunkt 405 die durch die Indexvariable referenzierte Stützstelle aus dem Datenspeicher 91 aufgerufen. Bei Programmpunkt 410 wird durch Vergleich geprüft, ob diese Stützstelle größer als der für die Sendeleistung m vorgegebene maximale Steuersignalwert 6, 7 ist. Ist dies der Fall, so wird zu Programmpunkt 415 verzweigt, andernfalls wird zu Programmpunkt 425 verzweigt. Bei Programmpunkt 415 wird der vorgegebene maximale Steuersignalwert 6, 7 für die Sendeleistung m an den Digital-Analog-Wandler 60 abgegeben und die Programmsequenz beendet.

Bei Programmpunkt 425 wird die zuletzt ermittelte Stützstelle des Referenzsteuersignals 5 an den Digital-Analog-Wandler 60 abgegeben. Bei Programmpunkt 430 wird die Indexvariable inkrementiert, so daß sie auf die nächste auszugebende Stützstelle zeigt. Bei Programmpunkt 435 wird eine für alle Programmaufrufe und -durchläufe konstante Wartezeit, die von der gewünschten Taktrate der Stützstellenausgabe bestimmt wird, eingestellt. Bei Programmpunkt 440 wird geprüft, ob der soeben an den Digital-Analog-Wandler 60 ausgegebene Wert die letzte Stützstelle der Leistungsanhebung war und somit der Maximalwert $U_{C0}$ des Referenzsteuersignals 5 erreicht ist. Ist dies der Fall, so wird die Programmsequenz beendet, andernfalls wird zu Programmpunkt 405 verzweigt und die nächste Stützstelle aufgerufen.

Zu einem Zeitpunkt $t_1$ bzw. $t_1$ wird die Absenkung der Senderausgangsleistung gemäß Figur 8 eingeleitet, indem eine zweite Sequenz von Stützstellen des Referenzsteuersignals 5 beim Programmpunkt START 2 aufgerufen wird. Auch bei diesem Aufruf wird der Ablaufsteuerung 81 der Wert m für die gerade verwendete Leistungsstufe der Senderausgangsleistung durch die Basisstation per Funk angegeben. Bei Programmschritt 450 wird die Indexvariable mit der um 1 erhöhten Anzahl der bei dieser Leistungsstufe m zu überspringenden Stützstellen des Referenzsteuersignals 5 initialisiert, so daß sie jetzt auf die erste dem vorgegebenen maximalen Steuersignalwert 6, 7 entsprechende Stützstelle des Referenzsteuersignals 5 verweist. Bei Programmpunkt 455 wird die durch die Indexvariable referenzierte Stützstelle aus dem Datenspeicher 91 aufgerufen. Bei Programmpunkt 460 wird diese Stützstelle des Referenzsteuersignals 5 an den Digital-Analog-Wandler 60 abgegeben. Bei Programmpunkt 465 wird die Indexvariable inkrementiert und bei Programmpunkt 470 wird eine für alle Programmdurchläufe unveränderte Wartezeit eingestellt. Nach Ablauf dieser Wartezeit wird bei Programmpunkt 475 geprüft, ob die zuletzt ausgegebene Stützstelle der letzte Wert des Referenzsteuersignals 5 war. Ist dies der Fall, so wird zu Programmpunkt 480 verzweigt, andernfalls wird zu Programmpunkt 455 verzweigt und die nächste Stützstelle aufgerufen: Bei Programmpunkt 480 wird der Wert Null an den Digital-Analog-Wandler 60 übergeben und das Programm beendet.

In Figur 8 ist für m=3 Leistungsstufen des Senderausgangssignals der Verlauf der Spannung der jeweiligen Steuersignale $U_C$ über der Zeit t dargestellt. Bei einer Signalanhebung auf die maximale Senderausgangsleistung gemäß dem Maximalwert $U_{C0}$ des Referenzsteuersignals 5 werden alle Stützstellen des Referenzsteuersignals 5 verwendet, das heißt über den Digital-Analog-Wandler 60 an den nicht invertierenden Eingang (+) des Summierungspunktes 45 im Leistungsregelkreis ausgegeben. Somit ergibt sich der mit dem Bezugszeichen 5 gekennzeichnete Spannungsverlauf des Referenzsteuersignals am Ausgang des Digital-Analog-Wandlers 60. Das Referenzsteuersignal 5 setzt dabei zu einem Zeitpunkt $t_{m=1}$ ein, der gegenüber dem Zeitpunkt $t_0$ verzögert ist. Bei geringeren Leistungsstufen der benötigten Senderausgangsleistung ergeben sich gemäß Figur 5 die Spannungsverläufe für die Steuersignale 8, 9. Dabei setzt das erste Steuersignal 8 zu einem Zeitpunkt $t_{m=2}$, der gegenüber dem Zeitpunkt $t_{m=1}$ verzögert ist, ein und erreicht den maximal vorgegebenen Wert $U_{C1}$. Das zweite Steuersignal 9 setzt zum Zeitpunkt $t_{m=3}$ ein, der gegenüber dem Zeitpunkt $t_{m=2}$ verzögert ist, und erreicht als vorgegebenen Maximalwert den Wert $U_{C2}$, wobei der Wert $U_{C2}$ kleiner als der Wert $U_{C1}$ und der Wert $U_{C1}$ kleiner als der Wert $U_{C0}$ gemäß den vorangegangenen Beispielen gewählt ist. Die in Figur 8 gepunktet eingezeichneten Stützstellen werden beim Anheben der Senderausgangsleistung bei den Steuersignalen 8, 9 mit den Maximalwerten $U_{C1}$ und $U_{C2}$ nicht mehr ausgeführt und beim Absenken übersprungen.

Zum Zeitpunkt $t_1$ für das Referenzsteuersignal 5 und das erste Steuersignal 8 bzw. zum gegenüber dem Zeitpunkt $t_1$ verzögerten Zeitpunkt $t_1$ für das zweite Steuersignal 9 wird die Absenkung der senderausgangsleistung dann eingeleitet.

Durch das zweite Filter 40 werden die Spannungsstufen des vom Digital-Analog-wandler 60 kommenden Steuersignals 8, 9 geglättet und in einen kontinuierlich steigenden bzw. sinkenden spannungsverlauf überführt.

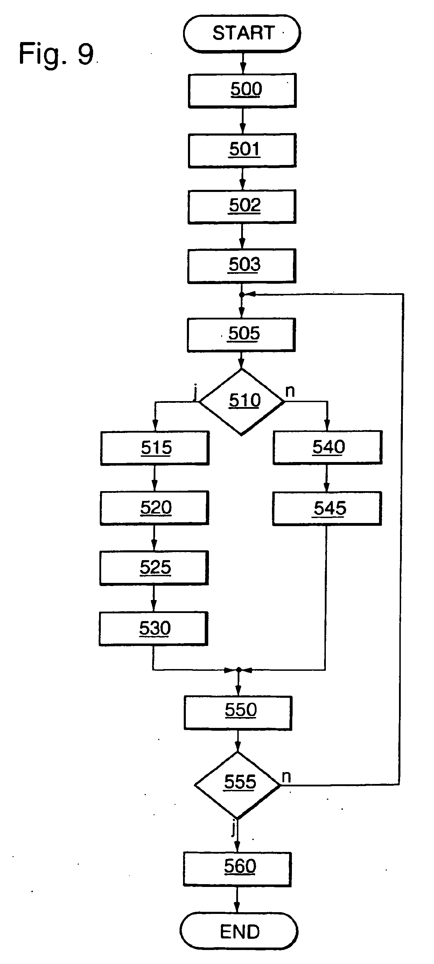

In einem Ausführungsbeispiel der Erfindung wird die bereits zuvor beschriebene Schaltung nach Figur 6 verwendet. Bei dem in Figur 9 dargestellten Ablaufplan der Ablaufsteuerung 81 wird jedoch nur eine einzige Sequenz von Stützstellen des Referenzsteuersignals 5, die beim Beginn der Sendesignalanhebung gestartet wird und erst nach Vollendung der Sendesignalabsenkung beendet wird, abgearbeitet. Für jede der m möglichen Leistungsstufen sind jeweils 5 Parameter im Datenspeicher 91 abgelegt: der vorgegebene maximale Steuersignalwert 6, 7 des für diese Leistungsstufe jeweils benötigten Steuersignals 8, 9 und vier Wartezeiten zwischen der Ausgabe von Stützstellen an den Digital-Analog-Wandler 60. Eine erste Wartezeit $t_{m1}$ gilt für die Zeitverzögerung des Sendebeginns, eine zweite Wartezeit $t_{m2}$ gilt für den Zeitraum des Anhebens der Senderausgangsleistung, eine dritte Wartezeit $t_{m3}$ gilt für den Zeitraum konstanter maximaler Senderausgangsleistung und eine vierte Wartezeit $t_{m4}$ gilt für den Zeitraum des Absenkens der Senderausgangsleistung.

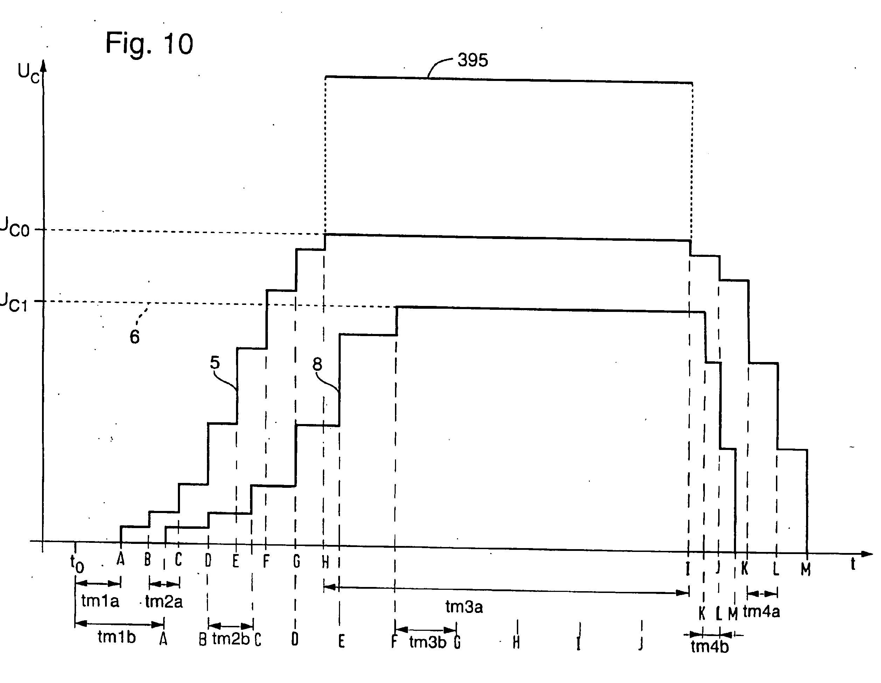

In Figur 10 ist der Verlauf der resultierenden Steuersignale $U_C$ für zwei Leistungsstufen m der Senderausgangsleistung über der Zeit t dargestellt.

Zum Zeitpunkt $t_0$ vor Beginn der Sendesignalanhebung wird die Sequenz der Stützstellen beim Programmpunkt START aufgerufen. Bei diesem Aufruf wird der Ablaufsteuerung 81 der Wert m für die gewünschte Leistungsstufe der Senderausgangsleistung durch eine Basisstation per Funk angegeben. Bei Programmpunkt 500 wird der Zugriff auf die erste Stützstelle des Referenzsteuersignals 5 durch Initialisierung einer ersten Indexvariablen $Z_1$ vorbereitet. Bei Programmpunkt 501 wird eine zweite Indexvariable $Z_2$ initialisiert, so daß sie auf die erste Wartezeit $t_{m1}$ für die gewählte Leistungsstufe m der Senderausgangsleistung zeigt. Bei Programmpunkt 502 wird die durch die zweite Indexvariable $Z_2$ referenzierte erste Wartezeit $t_{m1}$ aus dem Datenspeicher 91 aufgerufen. Nach Ablauf der ersten Wartezeit $t_{m1}$ wird bei Programmpunkt 503 die zweite Indexvariable $Z_2$ so gesetzt, daß sie nun auf die zweite Wartezeit $t_{m2}$ der gewählten Leistungsstufe m zeigt.

Bei Programmpunkt 505 wird die durch die erste Indexvariable $Z_1$ referenzierte Stützstelle aus dem Datenspeicher 91 aufgerufen. Bei Programmpunkt 510 wird durch einen Vergleich geprüft, ob diese Stützstelle größer oder gleich dem vorgegebenen maximalen Steuersignalwert 6, 7 der gewählten Leistungsstufe m ist. Ist dies der Fall, so wird zu Programmpunkt 515 verzweigt, andernfalls wird zu Programmpunkt 540 verzweigt. Bei Programmpunkt 515 wird der vorgegebene maximale Steuersignalwert 6, 7 für die gewählte Leistungsstufe m an den Digital-Analog-Wandler 60 abgegeben. Anschließend wird bei Programmpunkt 520 die zweite Indexvariable $Z_2$ so gesetzt, daß sie auf die dritte Wartezeit $t_{m3}$ der gewählten Leistungsstufe m zeigt. Bei Programmpunkt 525 wird die durch die zweite Indexvariable $Z_2$ referenzierte dritte Wartezeit $t_{m3}$ aus dem Datenspeicher 91 aufgerufen. Nach Ablauf der dritten Wartezeit $t_{m3}$ wird bei Programmpunkt 530 die zweite Indexvariable $Z_2$ auf die vierte Wartezeit $t_{m4}$ der gewählten Leistungsstufe m gesetzt. Anschließend wird Programmpunkt 550 ausgeführt.

Bei Programmpunkt 540 wird die bei Programmpunkt 505 aufgerufene Stützstelle an den Digital-Analog-Wandler 60 abgegeben. Bei Programmpunkt 545 wird die durch die zweite Indexvariable $Z_2$ referenzierte Wartezeit aufgerufen. Diese Wartezeit kann entweder die zweite Wartezeit $t_{m2}$ oder die vierte Wartezeit $t_{m4}$ für die gewählte Leistungsstufe m sein, je nachdem ob zuvor bereits der Programmzweig ab Programmpunkt 515 durchlaufen wurde oder nicht. Anschließend wird Programmpunkt 550 ausgeführt. Bei Programmpunkt 550 wird die erste Indexvariable $Z_1$ inkrementiert. Sie zeigt nun auf die nächste auszugebende Stützstelle. Bei Programmpunkt 555 wird geprüft, ob bereits die letzte zur Verfügung stehende Stützstelle ausgegeben wurde, also ob die erste Indexvariable $Z_1$ bereits über das Ende des Feldes gespeicherter Stützstellen hinauszeigt. Ist dies der Fall, so wird zu Programmpunkt 560 verzweigt, andernfalls wird zu Programmpunkt 505 verzweigt und dort wieder die nun anstehende Stützstelle aus dem Datenspeicher 91 geladen. Bei Programmpunkt 560 wird der Wert Null an den Digital-Analog-Wandler 60 abgegeben und das Programm beendet.

In Figur 10 ist der Verlauf der Spannung am Ausgang des Digital-Analog-Wandlers 60 für zwei Leistungsstufen m der Senderausgangsleistung dargestellt. Dabei ist zum einen das Referenzsteuersignal 5 mit dem maximalen Steuersignalwert $U_{C0}$ und zum anderen das erste Steuersignal 8 mit dem Maximalwert $U_{C1}$ des ersten vorgegebenen maximalen Steuersignalwertes 6, das vom Referenzsteuersignal 5 abgeleitet ist, dargestellt. Das Referenzsteuersignal 5 setzt um die erste Wartezeit $t_{m1a}$ gegenüber der Einschaltzeit $t_0$ verzögert ein und das vom Referenzsteuersignal 5 abgeleitete erste Steuersignal 8 setzt um eine erste Wartezeit $t_{m1b}$ gegenüber dem Einschaltzeitpunkt $t_0$ verzögert ein. Dabei ist die Wartezeit $t_{m1b}$ für das vom Referenzsteuersignal 5 abgeleitete erste Steuersignal 8 größer als die erste Wartezeit $t_{m1a}$ für das Referenzsteuersignal 5. Die zweite Wartezeit für den zeitlichen Abstand zwischen zwei Stützstellen beim Referenzsteuersignal 5 ist in Figur 10 mit $t_{m2a}$ gekennzeichnet und kleiner als die zweite Wartezeit $t_{m2b}$ für den zeitlichen Abstand zwischen zwei Stützstellen für das vom Referenzsteuersignal 5 abgeleitete erste Steuersignal 8 während dem Signalanstieg. Während das Referenzsteuersignal 5 und das vom Referenzsteuersignal 5 abgeleitete erste Steuersignal 8 ihre Maximalwerte aufweisen, entspricht der zeitliche Abstand zwischen zwei Stützstellen beim Referenzsteuersignal 5 der dritten Wartezeit $t_{m3a}$ und beim vom Referenzsteuersignal 5 abgeleiteten ersten Steuersignal 8 $t_{m3b}$. Dabei ist die dritte Wartezeit $t_{m3b}$ des vom Referenzsteuersignal 5 abgeleiteten ersten Steuersignals 8 kleiner als die dritte Wartezeit $t_{m3a}$ des Referenzsteuersignals 5. Der zeitliche Abstand zwischen zwei Stützstellen entspricht während der Signalabsenkung beim vom Referenzsteuersignal 5 abgeleiteten ersten Steuersignal 8 der vierten Wartezeit $t_{m4b}$ und ist kleiner als die entsprechende vierte Wartezeit $t_{m4a}$ des Referenzsteuersignals 5. Dabei sind die Wartezeiten $t_{m1}$ bis $t_{m4}$ so gewählt, daß sowohl für das Referenzsteuersignal 5 als auch für das vom Referenzsteuersignal 5 abgeleitete erste Steuersignal 8 alle Stützstellen der im Datenspeicher 91 gespeicherten Sequenz aufgerufen wurden. Durch Wahl der zweiten und der vierten Wartezeiten $t_{m2}$ und $t_{m4}$ kann die Steigung der Leistungsanhebung und -absenkung individuell für jede Leistungsstufe m der Senderausgangsleistung festgelegt werden. Die dritten Wartezeiten $t_{m3}$ werden so dimensioniert, daß während der Zeit konstanter maximaler Sendeleistung die für die entsprechende Leistungsstufe m nicht benötigten Stützstellen höherer Sendeleistung aufgerufen, aber aufgrund des Pegelvergleichs nicht an den Digital-Analog-Wandler 60 weitergeleitet werden, so daß zum gewünschten Zeitpunkt der beginnenden Pegelabsenkung gerade die hierfür benötigte Stützstelle zur Bearbeitung im Datenspeicher 91 anliegt.

Die Zeitpunkte für die Weiterleitung der Stützstellen an den Digital-Analog-Wandler 60 sind sowohl für das Referenzsteuersignal 5 als auch für das erste Steuersignal 8 mit den Großbuchstaben A, B, C,..., M unterhalb der Zeitachse jeweils gekennzeichnet.

Bei dem Ablaufplan gemäß Figur 9 ist sicherzustellen, daß bei allen m zur Verfügung stehenden Leistungsstufen des Senderausgangssignals bei Programmpunkt 510 nach Beendigung der Sendersignalanhebung zu Programmpunkt 515 verzweigt wird, so daß im Anschluß bei Programmpunkt 520 die dritte Wartezeit $t_{m3}$ der gewählten Leistungsstufe m eingestellt werden kann. Dies ist die Voraussetzung für die spätere Sendesignalabsenkung mit der vierten Wartezeit $t_{m4}$. Da die Stützstelle des Referenzsteuersignals 5, die dem Maximalwert der entsprechend gewählten Leistungsstufe entspricht, nicht größer als der maximal vorgebbare wert $U_{C0}$ des Referenzsteuersignals 5 sein kann, was besonders für die Leistungsstufe mit der größtmöglichen Senderausgangsleistung gilt, ist daher diese Stützstelle mit dem Maximalwert $U_{C0}$ entsprechend zu erhöhen. Dies kann beispielsweise dadurch erreicht werden, daß in der im Datenspeicher 91 gespeicherten Tabelle der Stützstellen des Referenzsteuersignals 5 zwischen dem Bereich der Sendesignalanhebung und dem Bereich der Sendesignalabsenkung ein für die Ansteuerung des Regelkreises nicht geeigneter Wert eingefügt wird, der in Figur 10 mit dem Bezugszeichen 395 markiert ist und deutlich größer ist als der maximal vorgebbare Wert $U_{C0}$ des Referenzsteuersignals 5.

Während den Wartezeiten $t_{m1}$, $t_{m2}$, $t_{m3}$, $t_{m4}$ kann die Ablaufsteuerung 81 von der Programmausführung freigestellt werden und zur Abarbeitung anderer Aufgaben herangezogen werden.

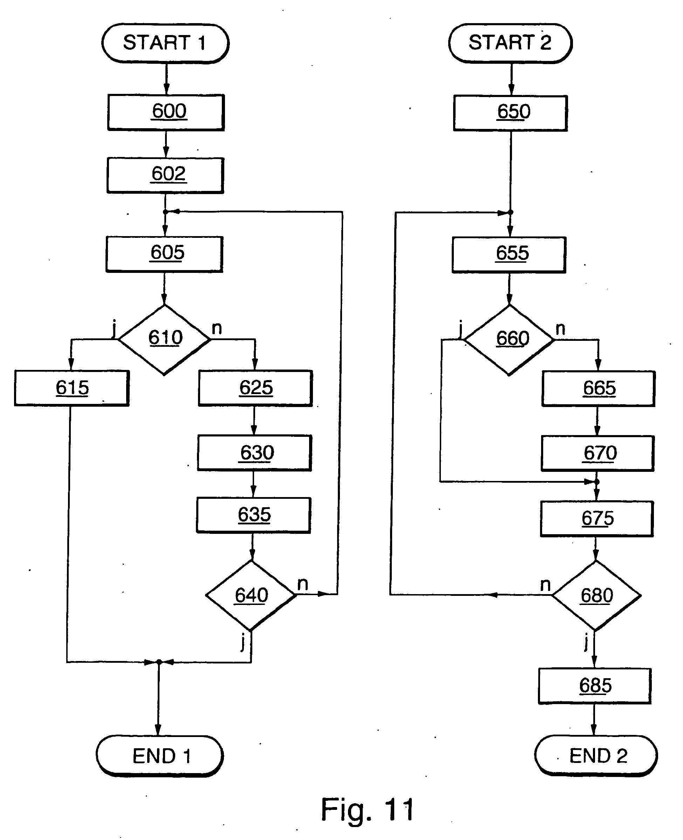

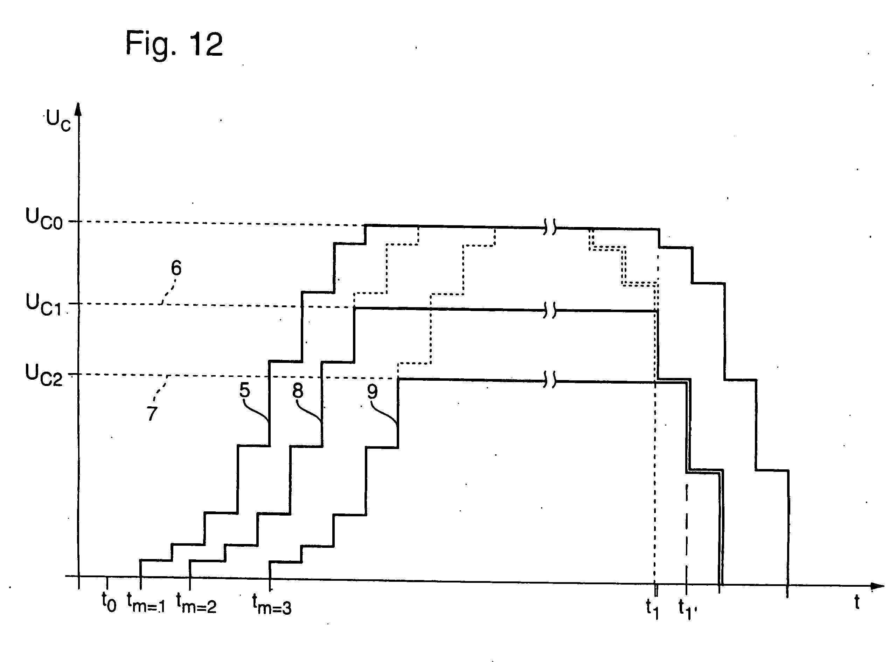

In einem weiteren Beispiel wird die bereits zuvor beschriebene Schaltung nach Figur 6 verwendet. In Figur 11 sind zwei Ablaufpläne zur Erzeugung des für eine gewünschte Sendeausgangsleistung benötigten Steuersignals 8, 9 dargestellt. In Figur 12 ist für drei Leistungsstufen des Senderausgangssignals der Verlauf der Spannungen der Steuersignale 8, 9 über der Zeit t dargestellt. Dabei wurden für die maximal vorgegebenen Steuersignalwerte 6, 7 wieder die Werte $U_{C1}$ und $U_{C2}$ gemäß den Figuren 3 und 5 gewählt. Der Maximalwert $U_{C0}$ des Referenzsteuersignals 5 wird ebenfalls gemäß den Figuren 3 und 5 gewählt. Für jede der m möglichen Leistungsstufen ist jeweils ein Wert für die Zeitverzögerung des Sendebeginns und den vorgegebenen maximalen Steuersignalwert 6, 7 des für diese Leistung benötigten Steuersignals 8, 9 im Datenspeicher 91 abgelegt.

Zu einem Zeitpunkt $t_0$ vor Beginn der Sendesignalanhebung wird eine erste Sequenz von Stützstellen des Referenzsteuersignals 5 beim Programmpunkt START 1 aufgerufen. Bei diesem Aufruf wird der Ablaufsteuerung 81 der Wert m für die gewünschte Leistungsstufe der Senderausgangsleistung durch eine Basisstation per Funk angegeben. Bei Programmpunkt 600 wird der Zugriff auf die im Datenspeicher 91 abgelegte erste Stützstelle der ersten Sequenz des Referenzsteuersignals 5 durch Initialisierung einer Indexvariablen vorbereitet. Bei Programmpunkt 602 wird der für die gewünschte Leistungsstufe m abgespeicherte Wert für die Zeitverzögerung des Sendebeginns $t_m$ aus dem Datenspeicher 91 ausgelesen. Nach Ablauf der Wartezeit $t_m$ wird bei Programmpunkt 605 die durch die Indexvariable referenzierte Stützstelle aus dem Datenspeicher 91 aufgerufen. Bei Programmpunkt 610 wird durch Vergleich geprüft, ob diese Stützstelle größer als der für die gewünschte Leistungsstufe m vorgegebene maximale Steuersignalwert 6, 7 ist. Ist dies der Fall, so wird zu Programmpunkt 615 verzweigt, andernfalls wird zu Programmpunkt 625 verzweigt. Bei Programmpunkt 615 wird der vorgegebene maximale Steuersignalwert 6, 7 für die gewünschte Leistungsstufe m an den Digital-Analog-Wandler 60 abgegeben und die Programmsequenz beendet.

Bei Programmpunkt 625 wird die zuletzt ermittelte Stützstelle des Referenzsteuersignals 5 an den Digital-Analog-Wandler 60 abgegeben. Bei Programmpunkt 630 wird die Indexvariable inkrementiert, so daß sie auf die nächste auszugebende Stützstelle zeigt. Bei Programmpunkt 635 wird eine für alle Programmaufrufe und -durchläufe konstante Wartezeit, die von der gewünschten Taktrate der Stützstellenausgabe bestimmt wird, eingestellt. Bei Programmpunkt 640 wird geprüft, ob der soeben an den Digital-Analog-Wandler 60 ausgegebene Wert die letzte Stützstelle der Leistungsanhebung war und somit der Maximalwert $U_{C0}$ des Referenzsteuersignals 5 erreicht ist. Ist dies der Fall, so wird die Programmsequenz beendet, andernfalls wird zu Programmpunkt 605 verzweigt und die nächste Stützstelle aufgerufen.

Zu einem Zeitpunkt $t_1$ bzw. $t_i$ wird die Absenkung der Senderausgangsleistung gemäß Figur 12 eingeleitet, indem eine zweite Sequenz von Stützstellen des Referenzsteuersignals 5 beim Programmpunkt START 2 aufgerufen wird. Auch bei diesem Aufruf wird der Ablaufsteuerung 81 der Wert m für die gerade verwendete Leistungsstufe der Senderausgangsleistung angegeben. Bei Programmschritt 650 wird die Indexvariable so initialisiert, daß sie auf den Beginn des zweiten Signalabschnitts, also die erste für die Sendesignalabsenkung abgespeicherte Stützstelle des Referenzsteuersignals 5 verweist. Diese Initialisierung der Indexvariablen kann jedoch entfallen, wenn in der entsprechenden Speicherzelle noch die Stützstelle aus der ersten Sequenz gespeichert und abrufbar ist, und unter der Voraussetzung, daß die Stützstellen für die Sendesignalanhebung und -absenkung als ununterbrochenes Datenfeld sequentiell im Datenspeicher 91 abgelegt sind.

Bei Programmpunkt 655 wird die durch die Indexvariable referenzierte Stützstelle aus dem Datenspeicher 91 aufgerufen. Bei Programmpunkt 660 wird geprüft, ob diese Stützstelle größer als der für die vorgegebene Leistungsstufe m vorgegebene maximale Steuersignalwert 6, 7 ist. Ist dies der Fall, so wird zu Programmpunkt 675 verzweigt, andernfalls wird zu Programmpunkt 665 verzweigt. Bei Programmpunkt 665 wird diese Stützstelle des Referenzsteuersignals 5 an den Digital-Analog-Wandler 60 ausgegeben und bei Programmpunkt 670 wird eine für alle Durchläufe dieses Programmzweigs unveränderliche Wartezeit ausgeführt.

Bei Programmpunkt 675 wird die Indexvariable inkrementiert. Bei Programmpunkt 680 wird geprüft, ob die zuletzt ausgegebene Stützstelle die letzte Stützstelle des Referenzsteuersignals 5 war. Ist dies der Fall, so wird zu Programmpunkt 685 verzweigt, andernfalls wird zu Programmpunkt 655 zurückverzweigt und die nächste Stützstelle aufgerufen. Bei Programmpunkt 685 wird der Wert 0 an den Digital-Analog-Wandler 60 übergeben und das Programm beendet. In Figur 12 ist für m=3 Leistungsstufen des Senderausgangssignals der Verlauf der Spannung der jeweiligen Steuersignale $U_C$ über der Zeit t dargestellt. Die Darstellung gemäß Figur 12 entspricht dabei der Darstellung gemäß Figur 8, wobei in diesem Beispiel die gepunktet eingezeichneten Stützstellen beim Absenken der Senderausgangsleistung aufgrund des Ergebnisses des Pegelvergleichs nicht an den Digital-Analog-Wandler 60 übermittelt werden.

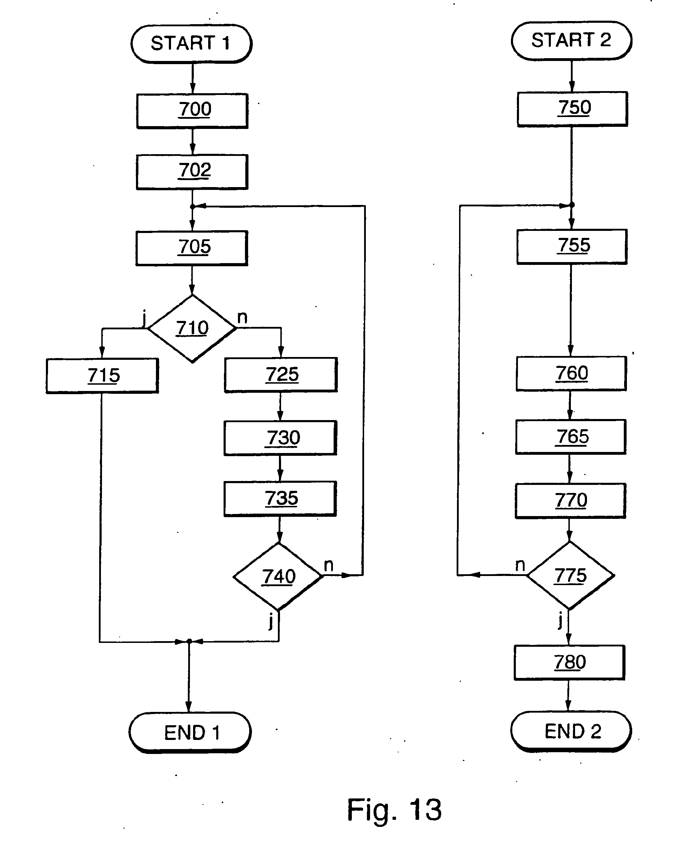

In einem weiteren Beispiel wird wiederum die bereits zuvor beschriebene Schaltung gemäß Figur 6 verwendet. Die Ablaufpläne zu diesem Beispiel sind in Figur 13 dargestellt. Wie bereits im zuvor beschriebenen Beispiel werden auch in diesem Beispiel zwei Ablaufpläne zur Erzeugung des für eine gewünschte Senderausgangsleistung benötigten Steuersignals 8, 9 verwendet. Ein erster mit START 1 gekennzeichneter Ablaufplan wird zum Anheben des Sendesignalpegels abgearbeitet und ein zweiter mit START 2 gekennzeichneter Ablaufplan bewirkt das gewünschte Absenken des Sendesignalpegels.

Bei diesem Beispiel erfolgt keinerlei Pegelvergleich zwischen den Stützstellen des Referenzsteuersignals 5 und dem für die gewünschte Leistungsstufe m vorgegebenen maximalen Steuersignalwert 6, 7. Dabei wird nur eine Teilsequenz von Stützstellen des Referenzsteuersignals 5 über den Digital-Analog-Wandler 60 an den Regelkreis ausgegeben.

Für jede der m möglichen Leistungsstufen sind jeweils vier Parameter im Datenspeicher 91 abgelegt. Dies ist zunächst ein Pegelwert für den flachen Mittelteil des Sendebursts, der während der Datenübermittlung konstant anliegt. Bei diesem Beispiel kann dieser Pegelwert geringer sein als einige Stützstellen der jeweils für die Leistungsstufe m verwendeten Teilsequenz des Referenzsteuersignals 5, da bei der Auswahl der jeweils benötigten Teilsequenz nicht der Signalpegel als Entscheidungskriterium herangezogen wird. Weiterhin sind für jede Leistungsstufe m die Wartezeit $t_m$ vor der Ausgabe der ersten Stützstelle, die Anzahl der beim Anheben des Sendesignals zu bearbeitenden Stützstellen und die Anzahl der vor dem Absenken des Sendesignals zu überspringenden Stützstellen gespeichert.

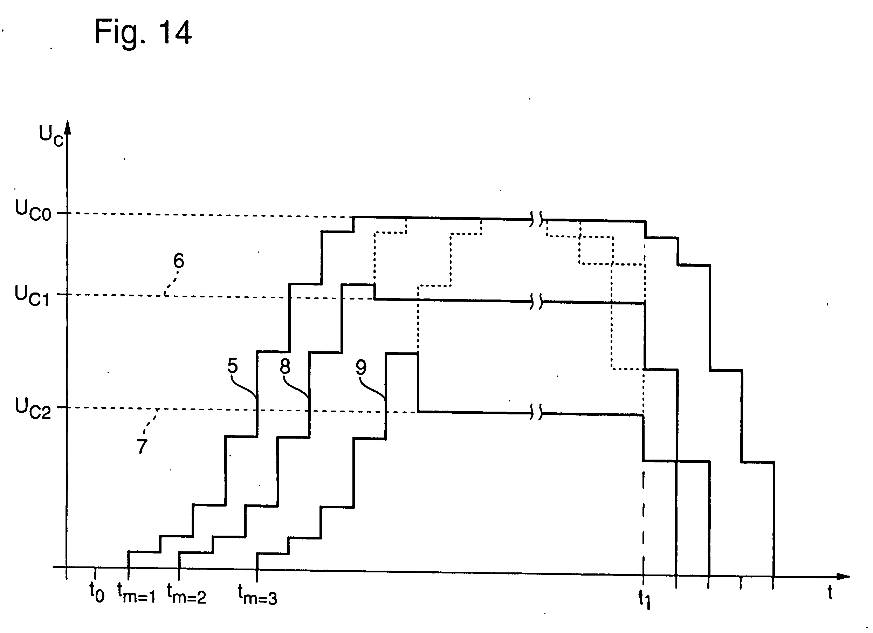

Zu einem Zeitpunkt $t_0$ vor Beginn der Sendesignalanhebung gemäß Figur 14 wird die erste Sequenz des Referenzsteuersignals 5 gemäß dem Ablaufplan in Figur 13 bei START 1 aufgerufen. Bei diesem Aufruf wird der Ablaufsteuerung 81 der Wert m für die gewünschte Leistungsstufe der Senderausgangsleistung durch eine Basisstation per Funk angegeben. Bei Programmpunkt 700 wird der Zugriff auf die erste Stützstelle des Referenzsteuersignals 5 durch Initialisierung der Indexvariablen vorbereitet. Der jeweilige Wert der Indexvariablen bildet bei den nachfolgenden Programmschleifen-Durchläufen nicht nur einen Zeiger auf die zu bearbeitende Stützstelle, sondern repräsentiert auch die Anzahl der bereits bearbeiteten Stützstellen.

Bei Programmpunkt 702 wird der für die gewünschte Leistungsstufe m abgespeicherte Wert der Wartezeit $t_m$ aus dem Datenspeicher 91 gelesen. Nach Ablauf der Wartezeit $t_m$ wird bei Programmpunkt 705 die durch die Indexvariable referenzierte Stützstelle aus dem Datenspeicher 91 aufgerufen. Bei Programmpunkt 710 wird anhand des aktuellen Wertes der Indexvariablen geprüft, ob die Anzahl der zuvor schon ausgegebenen Stützstellen bereits den Wert erreicht hat, der beim Anheben des Sendesignals für die Leistungsstufe m vorgesehen, also im Datenspeicher 91 eingetragen wurde. Ist dies der Fall, so wird zu Programmpunkt 715 verzweigt, andernfalls wird zu Programmpunkt 725 verzweigt. Bei Programmpunkt 715 wird der Pegelwert für den flachen Mittelteil des Steuersignals 8, 9 für die gewünschte Leistungsstufe m an den Digital-Analog-Wandler 60 ausgegeben und der Programmteil beendet.

Bei Programmpunkt 725 hingegen wird die zuletzt ermittelte Stützstelle des Referenzsteuersignals 5 an den Digital-Analog-Wandler 60 ausgegeben. Bei Programmpunkt 730 wird die Indexvariable inkrementiert, so daß sie auf die nächste auszugebende Stützstelle zeigt. Bei Programmpunkt 735 wird eine für alle Programmaufrufe und -durchläufe konstante Wartezeit eingestellt, die von der gewünschten Taktrate der Stützstellenausgabe bestimmt wird. Bei Programmpunkt 740 wird geprüft, ob der soeben an den Digital-Analog-Wandler 60 ausgegebene Wert die letzte Stützstelle der Leistungsanhebung war und somit der Maximalwert $U_{C0}$ des Referenzsteuersignals 5 erreicht ist. Ist dies der Fall, so wird der Programmteil beendet, andernfalls wird zu Programmpunkt 705 verzweigt und die nächste Stützstelle aufgerufen.

Zu einem Zeitpunkt $t_1$ gemäß Figur 14 wird die Absenkung der Senderausgangsleistung eingeleitet, indem die zweite Sequenz von Stützstellen des Referenzsteuersignals 5 bei Programmpunkt START 2 aufgerufen wird. Auch bei diesem Aufruf wird der Ablaufsteuerung der Wert m für die gerade verwendete Leistungsstufe der Senderausgangsleistung durch die Basisstation per Funk angegeben. Bei Programmpunkt 750 wird die Indexvariable mit der um 1 erhöhten Anzahl der bei dieser Leistungsstufe m zu überspringenden Stützstellen initialisiert, so daß sie jetzt auf die erste für diese Senderausgangsleistung auszugebende Stützstelle des Referenzsteuersignals 5 verweist. Bei Programmpunkt 755 wird die durch die Indexvariable referenzierte Stützstelle aus dem Datenspeicher 91 aufgerufen. Bei Programmpunkt 760 wird diese Stützstelle des Referenzsteuersignals 5 an den Digital-Analog-Wandler 60 ausgegeben. Bei Programmpunkt 765 wird die Indexvariable inkrementiert und bei Programmpunkt 770 wird eine für alle Programmdurchläufe unveränderliche Wartezeit ausgeführt.

Bei Programmpunkt 775 wird geprüft, ob die zuletzt ausgegebene Stützstelle der letzte Wert des Referenzsteuersignals 5 war. Ist dies der Fall, so wird zu Programmpunkt 780 verzweigt, andernfalls wird zu Programmpunkt 755 zurückverzweigt und die nächste Stützstelle aufgerufen. Bei Programmpunkt 780 wird der Wert Null an den Digital-Analog-Wandler 60 übergeben und das Programm beendet.

In Figur 14 sind für m=3 Leistungsstufen des Senderausgangssignals die Spannungsverläufe der Steuersignale $U_C$ über der Zeit t dargestellt. Bei Signalanhebung auf die maximale Senderausgangsleistung werden alle Stützstellen des Referenzsteuersignals 5 verwendet, das heißt über den Digital-Analog-Wandler 60 an den nicht invertierenden Eingang (+) des Summierungspunktes 45 im Leistungsregelkreis ausgegeben. Somit ergibt sich am Ausgang des Digital-Analog-Wandlers 60 der Spannungsverlauf des Referenzsteuersignals 5, der zu einem Zeitpunkt $t_{m=1}$ einsetzt, der gegenüber dem Zeitpunkt $t_0$ verzögert ist. Bei niedrigeren Leistungsstufen m der benötigten Senderausgangsleistung ergeben sich die beiden Steuersignale 8, 9, wobei das erste Steuersignal 8 zu einem Zeitpunkt $t_{m=2}$ einsetzt, der gegenüber dem Zeitpunkt $t_{m=1}$ verzögert ist und das zweite Steuersignal 9 zu einem Zeitpunkt $t_{m=3}$ einsetzt, der gegenüber dem Zeitpunkt $t_{m=2}$ verzögert ist. Dabei ist gut zu erkennen, daß in diesem Beispiel die letzten ausgegebenen stützstellen des Referenzsteuersignals 5 bei der Anhebung der Senderausgangsleistung größer sind als der für den flachen Mittelteil des Sendebursts, also während der Datenübermittlung verwendete Pegelwert. Die gepunktet eingezeichneten Stützstellen werden beim Anheben der Senderausgangsleistung nicht mehr ausgeführt und beim Absenken der Senderausgangsleistung übersprungen.

Der während der Datenübermittlung verwendete Pegelwert beträgt gemäß Figur 14 für das Referenzsteuersignal 5 den Maximalwert $U_{C0}$ des Referenzsteuersignals 5, für das erste Steuersignal 8 den Maximalwert $U_{C1}$, der dem ersten vorgegebenen maximalen Steuersignalwert 6 entspricht, und für das zweite Steuersignal 9 den Maximalwert $U_{C2}$, der dem zweiten vorgegebenen maximalen Steuersignalwert 7 entspricht.

**Patentansprüche**

1. Verfahren zur Regelung der Leistungsverstärkung für die Abstrahlung eines Sendesignals von einer Funkvorrichtung, wobei die Abstrahlleistung zu Beginn des Sendesignals entlang einer vorgegebenen Kennlinie auf eine vorgegebene Leistung angehoben und zu Ende des Sendesignals entlang der vorgegebenen Kennlinie abgesenkt wird, und wobei die Leistungsverstärkung durch ein Steuersignal (8) entsprechend gesteuert wird, wobei für die ansteigende und abfallende Flanke des Steuersignals (8) ein Referenzsteuersignal (5) verwendet wird, das als Sequenz von Stützstellen in einem Datenspeicher (91) abgelegt ist, und wobei das Steuersignal (8) auf einen vorgegebenen maximalen Steuersignalwert (6) begrenzt wird,
**dadurch gekennzeichnet, dass**
für das vom Referenzsteuersignal (5) abgeleitete Steuersignal (8) in Abhängigkeit des vorgegebenen maximalen Steuersignalwertes (6)

- eine erste Wartezeit ($t_{m1b}$), die die Verzögerung des Einsetzens des Steuersignals (8) gegenüber einem Einschaltzeitpunkt ($t_0$) festlegt,
- eine zweite Wartezeit ($t_{m2b}$), die den zeitlichen Abstand zwischen zwei Stützstellen für das Steuersignal (8) während des Signalanstiegs festlegt,
- eine dritte Wartezeit ($t_{m3b}$), die den zeitlichen Abstand zwischen zwei Stützstellen für das Steuersignal (8), während das Steuersignal (8) seinen Maximalwert aufweist, festlegt, und
- eine vierte Wartezeit ($t_{m4b}$), die den zeitlichen Abstand zwischen zwei Stützstellen für das Steuersignal (8) während der Signalabsenkung festlegt, vorgegeben und gespeichert sind,

wobei die erste Wartezeit ($t_{m1b}$) für das Steuersignal (8) größer als die erste Wartezeit ($t_{m1a}$) ist, die die Verzögerung des Einsetzens des Referenzsteuersignals (5) gegenüber dem Einschaltzeitpunkt ($t_0$) festlegt,
die zweite Wartezeit ($t_{m2b}$) für das Steuersignal (8) größer als die zweite Wartezeit ($t_{m2a}$) ist, die den zeitlichen Abstand zwischen zwei Stützstellen für das Referenzsteuersignal (5) während des Signalanstiegs festlegt,
die dritte Wartezeit ($t_{m3b}$) für das Steuersignal (8) kleiner als die dritte Wartezeit ($t_{m3a}$) ist, die den zeitlichen Abstand zwischen zwei Stützstellen für das Referenzsteuersignal (5), während das Referenzsteuersignal (5) seinen Maximalwert aufweist, festlegt, und die vierte Wartezeit ($t_{m4b}$) für das Steuersignal (8) kleiner als die vierte Wartezeit ($t_{m4a}$) ist, die den zeitlichen Abstand zwischen zwei Stützstellen für das Referenzsteuersignal (5) während der Signalabsenkung festlegt,

wobei die Wartezeiten ($t_{m1b}$, $t_{m2b}$, $t_{m3b}$, $t_{m4b}$) für das Steuersignal (8) so gewählt werden, dass sowohl für das Referenzsteuersignal (5) als auch für das Steuersignal (8) alle Stützstellen der im Datenspeicher (91) gespeicherten Sequenz aufgerufen werden.

2. Verfahren nach Anspruch 1, **dadurch gekennzeichnet, dass** das Referenzsteuersignal (5) mit dem vorgegebenen maximalen Steuersignalwert (6) zu vorgegebenen Zeiten verglichen wird und dass bei Überschreiten des vorgegebenen maximalen Steuersignalwertes (6) das Steuersignal (8) auf diesen Wert begrenzt wird.

3. Verfahren nach Anspruch 1 oder 2, **dadurch gekennzeichnet, dass** zur Begrenzung des Steuersignals (8) vom Referenzsteuersignal (5) auf den vorgegebenen maximalen Steuersignalwert (6) umgeschaltet wird.

4. Verfahren nach einem der vorherigen Ansprüche, **dadurch gekennzeichnet, dass** die Sendesignale in Abhängigkeit der für ihre Abstrahlung vorgegebenen Leistung mit vorgegebenen Zeitversetzungen (15, 16) abgestrahlt werden.

5. Verfahren nach einem der vorherigen Ansprüche, **dadurch gekennzeichnet, dass** mit Abnahme der vorgegebenen Leistung das Einsetzen des Sendesignals verzögert wird.

6. Verfahren nach einem der vorherigen Ansprüche, **dadurch gekennzeichnet, dass** die Abstände zwischen den Zeiten, bei denen der Vergleich des Referenzsteuersignals (5) mit dem vorgegebenen maximalen Steuersignalwert (6) erfolgt, vorgegeben werden.

7. Verfahren nach einem der vorherigen Ansprüche, **dadurch gekennzeichnet, dass** der Umfang der vom Steuersignal (8) übernommenen Teile des Referenzsteuersignals (5) in Abhängigkeit von der vorgegebenen Leistung gewählt wird.

8. Verfahren nach einem der vorherigen Ansprüche, **dadurch gekennzeichnet, dass** mit Abnahme der vorgegebenen Leistung der Umfang der vom Steuersignal (8) nicht übernommenen Teile des Referenzsteuersignals (5) vergrößert wird.

9. Verfahren nach einem der vorherigen Ansprüche, **dadurch gekennzeichnet, dass** mit Hilfe eines Detektors (20) die tatsächlich erzielte Abstrahlleistung am Ausgang der Leistungsverstärkung ermittelt und als Regelgröße in einen Steuerungszweig der Leistungsverstärkung zurückgeführt wird.

## Claims

1. Method for power gain control for the emission of a transmission signal from a radio apparatus, with the emitted power being raised at the start of the transmission signal along a predetermined characteristic to a predetermined power level and being reduced at the end of the transmission signal along the predetermined characteristic, with the power gain being controlled appropriately by a control signal (8), with a reference control signal (5), which is stored in a data memory (91) as a sequence of support points, being used for the rising and falling flanks of the control signal (8) and with the control signal (8) being limited to a predetermined maximum control signal value (6), **characterized in that**

   for the control signal (8) which is derived from the reference control signal (5), as a function of the predetermined maximum control signal value (6)

   - a first waiting time ($t_{m1b}$), which defines the delay of the start of the control signal (8) with respect to a switching-on time (to),
   - a second waiting time ($t_{m2b}$), which defines the time interval between two support points for the control signal (8) during the signal rise,
   - a third waiting time ($t_{m3b}$), which defines the time interval between two support points for the control signal (8) while the control signal (8) is at its maximum value, and
   - a fourth waiting time ($t_{m4b}$), which defines the time interval between two support points for the control signal (8) during the signal decrease, are predetermined and stored,

   wherein the first waiting time ($t_{m1b}$) for the control signal (8) is greater than the first waiting time ($t_{m1a}$), which defines the delay of the start of the reference control signal (5) with respect to the switching-on time ($t_0$),
   the second waiting time ($t_{m2b}$) for the control signal (8) is greater than the second waiting time ($t_{m2a}$) which defines the time interval between two support points for the reference control signal (5) during the signal rise,
   the third waiting time ($t_{m3b}$) for the control signal (8) is less than the third waiting time ($t_{m3a}$) which defines the time interval between two support points for the reference control signal (5) while the reference control signal (5) is at its maximum value, and
   the fourth waiting time ($t_{m4b}$) for the control signal (8) is less than the fourth waiting time ($t_{m4a}$) which defines the time interval between two support points for the reference control signal (5) during the signal decrease,
   wherein the waiting times ($t_{m1b}$, $t_{m2b}$, $t_{m3b}$, $t_{m4b}$) for the control signal (8) are chosen such that all the support points of the sequence stored in the data memory (91) are called up for the reference control signal (5) and for the control signal (8).

2. Method according to Claim 1, **characterized in that** the reference control signal (5) is compared with the predetermined maximum control signal value (6) at predetermined times, and **in that**, if the predetermined maximum control signal function (6) is exceeded, the control signal (8) is limited to this value.

3. Method according to Claim 1 or 2, **characterized in that** the control signal (8) is limited by switching from the reference control signal (5) to the predetermined maximum control signal value (6).

4. Method according to one of the preceding claims, **characterized in that** the transmission signals are transmitted with predetermined time offsets (15, 16) as a function of the power predetermined for their transmission.

5. Method according to one of the preceding claims, **characterized in that** the start of the transmission signal is delayed with the decrease in the predetermined power.

6. Method according to one of the preceding claims, **characterized in that** the intervals between the times at which the reference control signal (5) is compared with the predetermined maximum control signal value (6) are predetermined.

7. Method according to one of the preceding claims, **characterized in that** the range of the parts of the reference control signal (5) which are transferred from the control signal (8) is selected as a function of the predetermined power.

8. Method according to one of the preceding claims, **characterized in that** the range of the parts of the reference control signal (5) which are not transferred from the control signal (8) is increased as the predetermined power decreases.

9. Method according to one of the preceding claims, **characterized in that** the emitted power that is actually achieved at the output of the power amplifier is determined with the aid of a detector (20) and is fed back as a controlled variable to a control branch of the power amplifier.

## Revendications

1. Procédé de régulation de l'amplification en puissance pour le rayonnement d'un signal émis d'un dispositif radioélectrique, la puissance de rayonnement croissant à partir du début du signal émis le long d'une courbe prédéfinie jusqu'à une puissance prédéfinie puis décroissant jusqu'à la fin du signal émis le long de la courbe prédéfinie, et l'amplification en puissance étant commandé en conséquence par un signal de commande (8), un signal de commande de référence (5) étant utilisé pour le front montant et le front descendant du signal de commande (8), lequel est enregistré sous la forme d'une séquence de points de référence dans une mémoire de données (91), et le signal de commande (8) étant limité à une valeur maximale prédéfinie du signal de commande (6),

**caractérisé en ce que**

pour le signal de commande (8) dérivé du signal de commande de référence (5), sont prédéfinis et enregistrés en fonction de la valeur maximale prédéfinie du signal de commande (6),

- un premier temps d'attente ($t_{m1b}$) qui définit le retard entre l'instant d'activation ($t_0$) et l'amorçage du signal de commande (8),

- un deuxième temps d'attente ($t_{m2b}$) qui définit l'écart dans le temps entre deux points de référence du signal de commande (8) pendant la croissance du signal,

- un troisième temps d'attente ($t_{m3b}$) qui définit l'écart dans le temps entre deux points de référence du signal de commande (8) pendant qu'il présente sa valeur maximale, et

- un quatrième temps d' attente ($t_{m4b}$) qui définit l'écart dans le temps entre deux points de référence du signal de commande (8) pendant la décroissance du signal,

le premier temps d' attente ($t_{m1b}$) du signal de commande (8) étant supérieur au premier temps d'attente ($t_{m1a}$) qui définit le retard entre l'instant d'activation ($t_0$) et l'amorçage du signal de commande de référence (5),

le deuxième temps d'attente ($t_{m2b}$) du signal de commande (8) étant supérieur au deuxième temps d'attente ($t_{m2a}$) qui définit l'écart dans le temps entre deux points de référence du signal de commande de référence (5) pendant la croissance du signal,

le troisième temps d'attente ($t_{m3b}$) du signal de commande (8) étant inférieur au troisième temps d'attente ($t_{m3a}$) qui définit l'écart dans le temps entre deux points de référence du signal de commande de référence (5) pendant que le signal de commande de référence (5) présente sa valeur maximale, et

le quatrième temps d'attente ($t_{m4b}$) du signal de commande (8) étant inférieur au quatrième temps d'attente ($t_{m4a}$) qui définit l'écart dans le temps entre deux points de référence du signal de commande de référence (5) pendant la décroissance du signal,

les temps d'attente ($t_{m1b}$, $t_{m2b}$, $t_{m3b}$, $t_{m4b}$) du signal de commande (8) étant choisis de telle sorte que tous les points de référence de la séquence enregistrée dans la mémoire de données (91) sont invoqués aussi bien pour le signal de commande (8) que pour le signal de commande de référence (5).

**2.** Procédé selon la revendication 1, **caractérisé en ce que** le signal de commande de référence (5) est comparé avec la valeur maximale prédéfinie du signal de commande (6) à des moments prédéfinis et qu'en cas de dépassement de la valeur maximale prédéfinie du signal de commande (6), le signal de commande (8) est limité à cette valeur.

**3.** Procédé selon la revendication 1 ou 2, **caractérisé en ce que** la limitation du signal de commande (8) est appliquée par un basculement du signal de commande de référence (5) sur la valeur maximale prédéfinie du signal de commande (6).

**4.** Procédé selon l'une des revendications précédentes, **caractérisé en ce que** les signaux émis sont rayonnés en fonction de la puissance prédéfinie pour leur rayonnement avec des décalages dans le temps (15, 16) prédéfinis.

**5.** Procédé selon l'une des revendications précédentes, **caractérisé en ce que** l'amorçage du signal émis est retardé à mesure que la puissance prédéfinie diminue.

**6.** Procédé selon l'une des revendications précédentes, **caractérisé en ce que** les écarts entre les instants auxquels a lieu la comparaison du signal de commande de référence (5) avec la valeur maximale prédéfinie du signal de commande (6) sont prédéfinis.

**7.** Procédé selon l'une des revendications précédentes, **caractérisé en ce que** l'étendue des parties du signal de commande de référence (5) qui sont prises en charge par le signal de commande (8) est choisie en fonction de la puissance prédéfinie.

**8.** Procédé selon l'une des revendications précédentes, **caractérisé en ce que** l'étendue des parties du signal de commande de référence (5) qui ne sont pas prises en charge par le signal de commande (8) augmente à mesure que la puissance prédéfinie diminue.

**9.** Procédé selon l'une des revendications précédentes, **caractérisé en ce que** la puissance de rayonnement effectivement obtenue à la sortie de l'amplification de puissance est déterminée à l'aide d'un détecteur (20) et renvoyée en tant que grandeur de régulation dans une branche de commande de l'am-

**EP 1 469 596 B1**

plification de puissance.

# Fig. 1

Fig. 2

```
        ┌──────────────┐
        │    START     │
        └──────┬───────┘
               │
               ▼
        ┌──────────────┐
        │     200      │
        └──────┬───────┘
               │
               ▼
        ┌──────────────┐
        │     205      │
        └──────┬───────┘
               │
               ▼
          ◇ 210 ◇
        j /      \ n
         ▼        ▼
    ┌───────┐  ┌───────┐
    │  215  │  │  225  │
    └───┬───┘  └───┬───┘
        ▼          ▼
    ┌───────┐  ┌───────┐
    │  220  │  │  230  │
    └───┬───┘  └───┬───┘
        └────┬─────┘
             ▼
        ┌───────┐
        │  235  │
        └───┬───┘
            ▼
          ◇ 240 ◇ n
            │ j
            ▼
        ┌──────────────┐
        │     END      │
        └──────────────┘
```

Fig. 3

# Fig. 4

Fig. 5

# Fig. 6

# Fig. 7

Fig. 8

$U_C$

$U_{C0}$

$U_{C1}$

$U_{C2}$

6

5

8

9

7

$t_0$  $t_{m=1}$  $t_{m=2}$  $t_{m=3}$

$t_1$  $t_{1'}$

$t$

Fig. 9

Fig. 10

EP 1 469 596 B1

Fig. 11

Fig. 12

Fig. 13

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5159283 A